# EUROPEAN PATENT APPLICATION

(11) **EP 2 769 967 A1**
(43) Date of publication of application: **27.08.2014**
(21) Application number: 12842188.0
(22) Date of filing: 19.10.2012
(51) Int. Cl.: C04B 35/52, B82Y 30/00, B82Y 40/00, C01B 31/02, H01M 4/96

(54) **DENSE MATERIAL INCLUDING CARBON NANOHORNS AND USE THEREOF**

(30) Priority: 19.10.2011 JP 2011229423
(71) Applicant: Environment Energy Nano Technical Research Institute, Kitaazumi-gun, Nagano 399-8602 (JP)
(72) Inventor: GOINO, Tadashi, Kitaazumi-gun, Nagano 399-8602 (JP); KITAMURA, Tsuzuki, Kitaazumi-gun, Nagano 399-8602 (JP)
(74) Representative: Duckworth, Timothy John
(86) International application number: PCT/JP2012/077152
(87) International publication number: WO 2013/058382

(57) **Abstract**

The purpose of disclosing the present description is to provide a dense material containing carbon nanohorns. For this purpose, the present description discloses the dense material containing carbon nanohorns and having a predetermined three-dimensional shape.

## Description

### Technical Field

The present description relates to a dense material containing carbon nanohorns and the use thereof.

### Background Art

Carbon substances having nanometer-scale microstructures, such as single-walled or multi-walled carbon nanotubes, carbon nanohorns, fullerenes, and nanocapsules, have recently attracted much attention. Such carbon substances are expected to find applications as nanostructured graphite substances for new electronic materials, catalysts, and optical materials. In particular, carbon nanohorns have attracted attention as substances that are the closest to practical use in electrode materials or gas-adsorbing materials of fuel cells.

On the other hand, in order to develop a wider range of application of such carbon nanomaterial, it is necessary to, for example, mold powdery carbon nanomaterial into a predetermined shape or form a composite of carbon nanomaterial together with another material. When providing a shape to the carbon nanomaterial, basic problems such as moldability and binding properties arise, while when forming a composite, other basic problems such as miscibility with another material, moldability, and strength arise.

Studies on the molding of the carbon nanomaterial and forming a composite of the carbon nanomaterial have been already proposed to a certain extent (Patent Literature 1 to 3).

### Citation List

### Patent Literature

Patent Literature 1: WO 2003/099717
Patent Literature 2: WO 2005/028100
Patent Literature 3: Japanese Patent Application Publication No. 2007-320802

### Summary

### Technical Problem

However, the carbon nanomaterial generally has shape anisotropy and involves problems of having hydrophobicity and being prone to aggregate. Moreover, the carbon nanomaterial involves a problem of having no binding property. Furthermore, the carbon nanomaterial involves problems of uniform dispersibility and affinity with another material. Therefore, although wider application of the carbon nanomaterial by molding and forming a composite has been expected, this has not been put into practical use due to serious problems.

Generally, although the carbon nanomaterial is required to exhibit at least a predetermined level of density, depending on application thereof, a mixture of materials in a mixture state in which carbon nanomaterial is uniformly present is required as a matter of course in order to obtain a dense material.

Hence, one objective in the present description is to provide a dense material including a carbon nanomaterial and the use thereof.

### Solution to Technical Problem

In consideration of the above-described problems, the inventors of the present teaching used a newly obtained carbon nanohorn in formation of a composite and found that the carbon nanohorn has favorable characteristics for molding and forming a composite. Moreover, the inventors of the present teaching found that a dense material can be obtained using this carbon nanohorn based on the characteristics. According to the present description, the following means can be provided based on these findings.
(1) A dense material comprising a carbon nanohorn,
   the material being a dense composite material containing a carbon nanohorn and having a predetermined three-dimensional shape.
(2) The dense material according to claim 1, which is a burned body.
(3) The dense material according to claim 1 or 2, which has a density of 1.0 g/cm3 or more.
(4) The dense material according to any of claims 1 to 3, wherein the pore volume of the carbon nanohorn is 0.8 cm3/g or more.
(5) The dense material according to any of claims 1 to 4, wherein
   the carbon nanohorn relates to one or more elements selected from the group consisting of Na, K, Mg, Ca, Fe, Si, and Cl and contains the one or more elements in the following contents:
   Na: 0.003% or more to 0.3% or less;
   K: 0.001% or more to 0.1% or less;
   Mg: 0.0005% or more to 0.05% or less;
   Ca: 0.004% or more to 0.4% or less;
   Fe: 0.006% or more to 0.6% or less;
   Si: 0.002% or more to 0.2% or less; and
   Cl: 0.004% or more to 0.4% or less.
(6) The dense material according to any of claims 1 to 5, wherein the carbon nanohorn is composed mainly of a carbon nanohorn with a length of 30 nm or less.
(7) The dense material according to any of claims 1 to 6, comprising a metal-supporting carbon nanohorn.
(8) The dense material according to any of claims 1 to 7, further comprising a ceramics material.
(9) The dense material according to any of claims 1 to 7, substantially comprising the carbon nanohorn.
(10) An electromagnetic shield material, comprising the desnse material according to any of claims 1 to 9.
(11) A method for producing a dense material containing carbon nanohorns,
   the method comprising:
   preparing a molding material containing a carbon nanohorn produced by arc discharge in a fluid; and
   heating and molding the molding material under pressure to produce the dense material according to any of claims 1 to 9.
(12) The method according to claim 11, wherein the molding material is prepared by mixing and drying the carbon nanohorn and another material in an aqueous medium.
(13) The method according to claim 11 or 12, wherein the molding material is pressurized at 20 kN or more and heated at 1000°C or more.

### Brief Description of Drawings

FIG. 1 shows schematically essential features of an example of an apparatus for producing a carbon nanomaterial disclosed in the present description.
FIG. 2 shows an example of a negative electrode disclosed in the present description.
FIG. 3 shows schematically essential features of second example of an apparatus for producing a carbon nanomaterial disclosed in the present description.
FIG. 4 shows essential features of third example of an apparatus for producing a carbon nanomaterial disclosed in the present description.
FIG. 5 shows essential features of fourth example of an apparatus for producing a carbon nanomaterial disclosed in the present description.
FIG. 6 is a logarithmic graph showing the particle size distribution of carbon nanohorn obtained in an example.
FIG. 7 shows bright field image of carbon nanohorn obtained in an example.
FIG. 8 shows bright field image of carbon nanohorn obtained in an example.
FIG. 9 shows bright field image of carbon nanohorn obtained in an example.
FIG. 10 shows bright field image of carbon nanohorn obtained in an example.
FIG. 11 shows evaluation reslts of Electromagnetic shielding characteristics.
FIG. 12 shows evaluation reslts of Electromagnetic shielding characteristics.

### Description of Embodiments

The present description relates to a dense material including a carbon nanohorn (hereinafter referred to as a dense material of the present teaching). According to the dense material disclosed in the present description, the dense material can be applied to the use according to the characteristics of the carbon nanohorn because it has a high density and favorable shape maintenance properties. The dense material of the present teaching uses a carbon nanohorn having hydrophilicity and a high pore volume. Thus, it is considered that the dense material is superior in handleability and can exhibit a superior performance in the use utilizing the structure of the carbon nanohorn.

The carbon nanomaterial disclosed in the present description can be synthesized in a fluid by arc discharge. According to the production method, by causing arc discharge to generate in a fluid and introducing inert gas into a region in which this arc discharge is generated, a carbon vapor can be effectively generated from graphite. Moreover, a carbon nanomaterial containing a single-layer carbon nanohorn can be generated from a carbon vapor. Furthermore, by the introduction of inert gas, energy profiles such as, for example, the quantity of electron to be discharged, a region to be heated by arc discharged, a heating temperature, and a pressure in a region in which arc discharge is generated can be controlled. Thus, the carbon nanomaterial to be generated can be prevented from being again vaporized. Moreover, by stirring the fluid, the carbon nanomaterial to be generated can be distanced from the region in which arc discharge is generated, and the carbon nanomaterial is prevented from being again vaporized, and further, each carbon nanomaterial can be prevented from being aggregated. Further, by causing the electrode cross-sectional area of cathode facing the graphite anode to be greater than the electrode cross-sectional area of the graphite anode, energy profiled in the range in which arc discharge is generated can be controlled. Thus, a large amount of the carbon nanomaterial can be generated.

This method can not only produce various carbon nanomaterials, but also easily separate between a single-layer carbon nanomaterial and a multi-layer carbon nanomaterial. Further, the generated carbon nanomaterial can be collected without stopping arc discharge. Therefore, the carbon nanomaterial can be continuously produced and collected.

The "carbon nanomaterial", as referred to in the present description, is inclusive of all of the carbon materials including carbon nanotubes, carbon nanohorns, fullerenes, nanographene, graphene nanoribbons, nanographite, and nanodiamond, and may be in the form of a monolayer or multilayer. Further, "nano", as referred to herein, is generally a size on a nanometer scale, but actually carbon materials that have expanded to a size of a micrometer scale can be also referred to as carbon nanoparticles. The method and apparatus for producing a carbon nanomaterial that are disclosed in the present description are particularly advantageous for producing multi-walled and single-walled carbon nanohorns.

In the present description, "%" means % by mass, unless otherwise indicated.

The "discharge", as referred to in the present description, is the process in which insulation breakdown occurs in a gas present between electrodes due to a difference in electric potential applied between the electrodes, electrons are emitted, and an electric current flows. The electric current released in this case can be called discharge current. In the discharge, for example, a spark discharge, a corona discharge, or dissociation and ionization of gas molecules occur, plasma is initiated, and the electric current runs thereon. Therefore, the discharge can be also called plasma arc discharge. In a space taken by the plasma in this process, the gas is in a state of excitation and has a high temperature, and a flash is produced. The arc discharge is preferred because it can be generated even at a normal temperature, provided that a high current flows, and also does not necessarily require a vacuum state.

"Positive electrode" and "negative electrode", as referred to in the present description, are electrodes capable of having electric conductivity. For example, materials including a metal, a ceramic, or carbon can be used for the electrodes. The electrodes may be also formed from one material or a plurality of materials selected from metals, ceramics, and carbon. An additive may be scattered over, applied to, or plated or coated on the entire surface of the electrode or part thereof. Such electrode materials can be acquired by a person skilled in the art by referring, as appropriate, to the conventional techniques. In order to prevent the negative electrode from consumption by the arc discharge, it is preferred that at least the negative electrode, from among the electrodes, be formed from a metal or ceramic material.

"Graphite", as referred to in the present description, is a material including carbon. In the present description, a positive electrode including carbon is referred to as graphite electrode. The graphite electrode can be an electrode for generating an arc discharge and also a starting material for carbon nanoparticles which are to be produced. In this case, it is preferred that the consumable graphite electrode be designed to be repeatedly replaceable. Further, when no graphite is used for the positive electrode, graphite as a starting material for the carbon nanomaterial is prepared separately from the electrode. When no graphite is used for the electrodes, electrode consumption can be prevented and the carbon nanomaterial can be produced at a low cost. Graphite may be in any form, and the suitable shape such as plate-like shape, can be selected as appropriate. Whether to use a graphite positive electrode or prepare graphite separately from the electrode can be determined, as appropriate, according to the design of the apparatus. In the present embodiment, the case is explained in which the graphite positive electrode is used.

The graphite may include only carbon, or may also include or incorporate an additive. Alternatively, the additive may be scattered over, applied to, or plated or coated on the entire graphite surface or part thereof. For example, when a metal such as iron or nickel is used as the additive, the metal nanoparticles can be encapsulated in the carbon nanohorns, that is, the metal nanoparticles can be introduced close to the center of carbon nanohorn particles which are nanoparticles in which closed short single-walled carbon nanotubes are aggregated into a spherical shape. A metal such as Pt may be used for coating. Pt excels in electric conductivity and catalytic activity, and by using such a positive electrode, it is possible to obtained a carbon nanomaterial forming a composite with a noble metal. Such carbon-including materials can be acquired by a person skilled in the art by referring, as appropriate, to the conventional techniques.

The "aqueous medium", as referred to in the present description, is a substance having stirring fluidity which is a liquid medium including water. In particular, an aqueous liquid demonstrating stirring fluidity at a temperature equal to or lower than the arc discharge generation temperature is preferred. For example, water or water-containing liquid mixtures, silicone oil, oils, aqueous solutions, liquid helium, and liquid nitrogen can be used. Among them, water is preferred because it is inexpensive, easy to procure, and easy to handle. Under the arc discharge conditions, the aqueous medium can have a smaller cluster structure and the redox potential thereof can be increased by comparison with those of water in the usual state. The miniaturization of the cluster structure and increase in redox potential of the aqueous medium can enhance the formation of carbon nanoparticles.

The "inert gas", as referred to in the present description, is a gas with poor chemical reactivity. Examples of the inert gases include elements of the 18th group (rare gases) constituted by helium, neon, argon, krypton, xenon, and radon, hydrazine, nitrogen gas, carbon dioxide, hydrogen gas, or mixtures thereof. Among them nitrogen gas is preferred because it is inexpensive and easy to procure. The inert gas can be stored as gas, or may be acquired as a liquid, or may be acquired as a solid, provided that it can be introduced as gas into the arc discharge generation region. The inactive substance of such a kind can be acquired, as appropriate, by a person skilled in the art by referring to the conventional techniques.

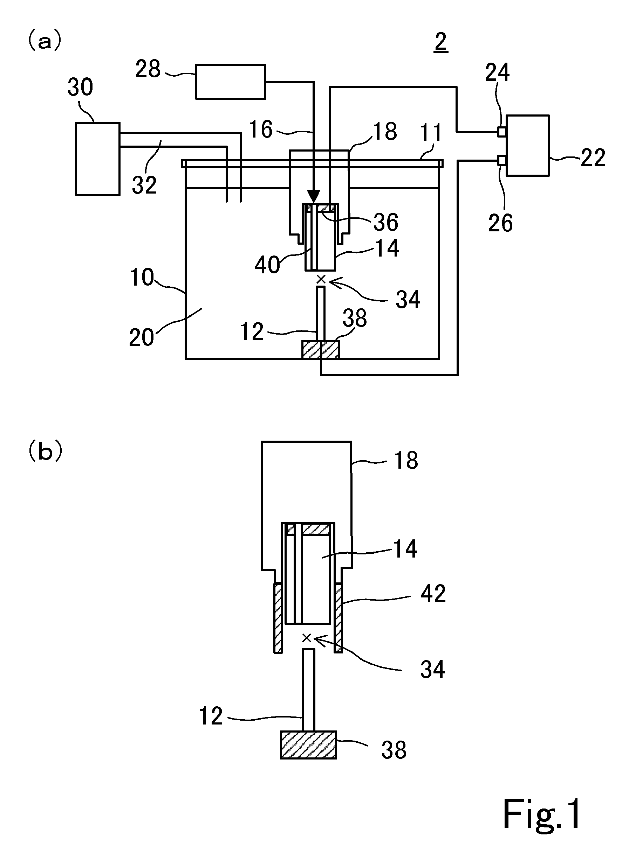

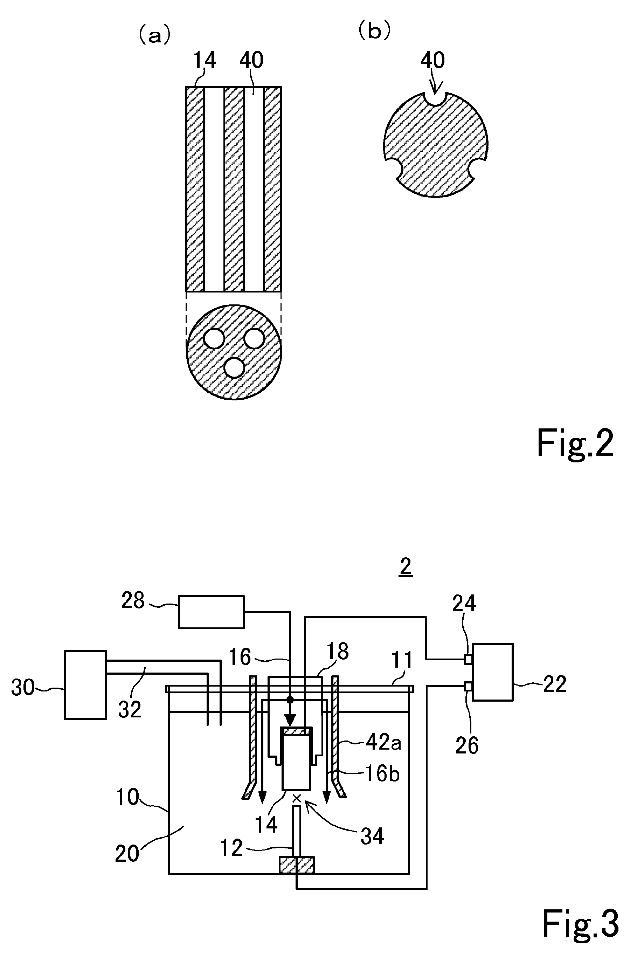

An embodiment of the present teaching will be explained hereinbelow with reference to the drawings. FIG. 1 shows schematically an example of the apparatus for producing a carbon nanohorn that is advantageous for producing the dense material of the present teaching. FIG. 2 shows an example in which a supply path for introducing the inert gas is formed in the negative electrode. First, carbon nanohorns are described below.explained.

### (Carbon nano horn)

Carbon nanohorn desclosed in the specification (hereinafter, referred to as the carbon nanohorn) has a form of a cone with a structure that contains carbon 5-membered rings at the vertex portion and 6-membered carbon rings mainly at the other cylindrical portion of the cone. The carbon nanohorn has a good dispersibility and the like and the following characteristics will be described below. The carbon nanohorn may be used as a raw material for the dense material and can be manufactured by the manufacturing method described below.

As described below, a dense molding can be obtained from the carbon nanohorn of the present teaching, and the dense molding can exert favorable characteristics of electromagnetic wave shield. Therefore, the carbon nanohorn of the present teaching is a useful material of electromagnetic shield material.

### (Hydrophilicity)

Although it is not theoretically clear, the carbon nanohorn of the present teaching is synthesized in an aqueous medium and thus has hydrophilicity. That is, the carbon nanohorn of the present teaching has favorable dispersibility to water compared with the conventional carbon nanohorn. For example, in a concentration range of 10% by mass or more to 100% by mass or less, a uniform dispersion state can be formed in water and methanol or ethanol. This dispersion state can be maintained for about 1 to 8 hours. Moreover, it has been known that when an ultrasonic treatment is performed for 15 minutes, the dispersion state can be maintained stably for a longer period of time.

The carbon nanohorn of the present teaching can be obtained as foam in the production method described below. The foam contains the carbon nanohorn of the present teaching, gas, and an aqueous medium. Although the gas may contain inert gas used in the production step, it is not particularly limited. Although the aqueous medium may contain an aqueous medium used in the production step, it is not particularly limited. The foam is accumulated on the aqueous medium in the production method of the present teaching. The foam obtained as described above can be subjected to solid-liquid separation and drying.

### (Pore volume)

The carbon nanohorn of the present teaching may have hydrophilicity and a pore volume of 0.8 cm3/g or more. The pore volume can be determined from the result of calculation of micropore distribution by the BJH method in the gas absorption method. As the gas, nitrogen gas can be used. More specifically, the pore volume can be determined by measuring an adsorption/desorption isotherm by nitrogen using a constant-volume method. The pore volume is preferably 0.9 or more, more preferably 1.0 or more. The upper limit of the pore volume is not particularly limited and can be, for example, about 1.2 or less. The magnitude of the pore volume means aggregation or accumulation of the carbon nanohorn with a high density. The pore volume relates to an absorption ability, a catalytic ability, an involving ability, and the like, and the magnitude of the pore volume means the magnitudes of the abilities.

### (Content of metal element and the like)

The carbon nanohorn of the present teaching relates to one or more elements selected from the group consisting of Na, K, Mg, Ca, Fe, Si, and Cl and preferably contains the one or more elements in the following contents:
Na: 0.003% or more to 0.3% or less;
K: 0.001 % or more to 0.1 % or less;
Mg: 0.0005% or more to 0.05% or less;
Ca: 0.004% or more to 0.4% or less;
Fe: 0.006% or more to 0.6% or less;
Si: 0.002% or more to 0.2% or less; and
Cl: 0.004% or more to 0.4% or less.

It is considered that, according to the carbon nanohorn having such composition, characteristics of carbon nanohorn is prone to be exerted. The preferred concentration ranges of the respective elements are shown below.
Na: 0.015% or more to 0.12% or less;
K: 0.005% or more to 0.04% or less;
Mg: 0.0025% or more to 0.02% or less;
Ca: 0.02% or more to 0.16% or less;
Fe: 0.03% or more to 0.24% or less;
Si: 0.01% or more to 0.08% or less; and
Cl: 0.02% or more to 0.16% or less.

The fruther preferred concentration ranges of the respective elements are shown below.
Na: 0.015% or more to 0.06% or less;
K: 0.005% or more to 0.02% or less;
Mg: 0.0025% or more to 0.01% or less;
Ca: 0.02% or more to 0.08% or less;
Fe: 0.03% or more to 0.12% or less;
Si: 0.01 % or more to 0.04% or less; and
Cl: 0.02% or more to 0.08% or less.

Na and K is preferably measured by atomic absorption, Mg, Ca, Fe, and Si are preferably measured ICP atomic emission spectroscopy, and Cl is preferably measured by an absorption/combustion IC method.

### (Size and shape)

The average length of the carbon nanohorn of the present teaching may be 30 nm or less. According to the transmission electron microscope image of the carbon nanohorn of the present teaching, the average length of the carbon nanohorn is 30 nm or less. The carbon nanohorn of the present teaching forms an aggregate having a diameter in a certain range. The shape of the aggregate is not a conventional dahlia-like shape. The carbon nanohorns as primary particles are irregularly aggregated to form secondary particles with an average aggregation diameter of 25 nm or more to 70 nm or less. The average aggregation diameter is preferably 40 nm or more to 60 nm or less.

### (Raman spectrum)

The carbon nanohorn of the present teaching can be found by a G band derived from graphite in the Raman spectrum of the carbon nanohorn.

### (Differential thermal analysis)

The carbon nanohorn of the present teaching can have a flammability peak (exothermic peak) in differential thermal analysis. The number of flammability peaks may be one or more. A flammability peak may be at 430°C or more to 530°C or less. Another flammability peak may be at 470°C or more to 740°C or less.

Moreover, the carbon nanohorn of the present teaching has the following characteristics.

The carbon nanomaterial obtained from a carbon material through the generation of an arc discharge in the inert gas cavity formed in situ in the aqueous medium has not only the properties common with the carbon nanomaterials represented by the conventional carbon nanotubes, but also different characteristics, although the origin thereof cannot be theoretically explained.

The carbon nanomaterial has a property of reducing the electric conductivity of carbon nanotubes serving as the conventional conductive material. Thus, the electric conductivity of the produced carbon nanomaterial tends to be lower than that of the conventional carbon nanotubes. For example, where the buckypaper from carbon nanotubes is impregnated with the present carbon nanomaterial, the sheet resistance (Ω/sq) and surface resistance (Ω/cm) are increased over those of the buckypaper constituted only by carbon nanotubes. Further, the electric conductivity (S/cm) thereof is decreased. Where buckypaper is fabricated by mixing the present carbon nanomaterial with carbon nanotubes, the properties tend to change in the same manner as in the buckypaper impregnated with the present carbon nanomaterial in comparison with those of the buckypaper constituted only by carbon nanotubes. Hence, the present carbon nanomaterial may be used as an electric conductivity adjustment material.

Further, where the present carbon nanomaterial is impregnated in a carbon nanotube layer, it demonstrates a property of improving the shape retaining ability and mechanical strength of the carbon nanotube layer. Thus, it is effective as a reinforcing material, in particular a reinforcing material for carbon nanotubes.

The present carbon nanomaterial is also useful as a friction material. As for, the usual graphite or carbon nanotubes are used as lubricating materials. By contrast, the present carbon nanomaterial has a property of increasing the friction coefficient of solid surfaces.

The carbon nanohorn of the present teaching may further have the following characteristics. For example, the carbon nanohorn may be processed to open a hole by oxidization using various oxidants. Moreover, in addition to the oxidization, the carbon nanohorn may have various organic functional groups.

A carbon nanomaterial containing the carbon nanohorn of the present teaching can be utilized in various uses according to the carbon nanohorn. For example, the carbon nanomaterial is useful as a material of an electrode (negative electrode or the like) in a fuel cell, a material of Li ion cell, a material of an electrode (negative electrode or the like) of a secondary cell, an absorbent, a carrier for DDS, a catalyst, or the carrier for the catalyst. Furthermore, the carbon nanohorns in the present teaching can be utilized in a nanocomposite, a dendrimer, a nanowire, a thin film having nanopores (porous thin film), a nanocantilever, nanoglass, an oxide nanosheet, a LB film material, a nanohybrid, a conductive ink, a conductive film, an electromagnetic wave absorber, an electric double-layer capacitor, a hydrogen-storing material, a wave absorber, an electrode material, and a sensor. Moreover, the carbon nanohorns in the present teaching can keep the freshness of plants and extend the blooming state of plants by adding the carbon nanohorns to water supplied to plants (including cut flowers) and can be used in a freshness-keeping agent of plants and a blooding extender of plants. The amount of the carbon nanohorns to be added to water can be set as appropriate considering the kind, the timing, and the state of plants.

The carbon nanomaterial disclosed in the present description can be used as a conductive polymer material, a nanocarbon coating material, an electron emission material, a field emission plane display material, conductive rubber, conductive paste, a methane storage material, a fluorine gas storage material, a high-transmittance shield, a magnetic nanoparticle, a biomaterial, a biological diagnostic material, an antibacterial material, microorganism killing material, a mycelium growing material, an antioxidant material, a plant activating material, a biosensor material, an organic semiconductor material, a conductive complex, radioactive noble gas storage, a material for artificial muscle, a material for artificial joint, a material for fixed bearing, a friction adjusting material, a nanotool, a supercapacitor, a magnetic nanomaterial, a battery, a nanobalance, nanotweezers, a data storage, a molecular quantum wire, disposing/recycling, doping, solar storage, an electromagnetic shield, a dialysis filter, heat prevention, nano reinforcing complex, a nano operating device, FET, a single-electron transistor, nanolithography, nanoelectronics, reinforcing material of a protective clothing and other materials, a reinforcing material of polymer, avionics parts, an impact protection material, a weld electrode material, and a flywheel. The carbon naomaterial in the present teaching can be used in components of an etching device, a sputtering device, and a CVD device and components of a vacuum processin apparatus thereof.

### (Method for producing carbon nanomaterial)

The method for producing a carbon nanomaterial including carbon nanohorns according to the present teaching includes: a step of generating arc discharge; and a step of introducing inert gas into a region in which the arc discharge is generated. More specifically, a carbon vapor is generated from graphite anode by arc discharge in water, and a carbon nanomaterial including carbon nanohorns is produced from the carbon vapor. The steps are described in detail below.

### (Step of generating arc discharge)

A step of forming a region in which arc discharge is generated, disclosed in the present description can be a step of applying a voltage between a cathode and an anode to form a region in which arc discharge is generated in a fluid that is present between the electrodes. According to this step, by vaporizing carbon provided in the region in which arc discharge is generated using arc discharge, a carbon vapor that can be a principle of a carbon nanomaterial can be generated.

In the present step, when a voltage is applied between a cathode and an anode, a discharge current flows between the electrodes, and arc discharge can be generated. Although the time for applying a voltage to generate arc discharge is not particularly limited, a short time is preferable because a generated carbon nanomaterial can be prevented from being again vaporized. By repeatedly performing short-time arc discharge, a large amount of carbon nanomaterial can be produced. Although the voltage to be applied may be a direct voltage or an alternating voltage, it is preferred that arc discharge is generated by applying a direct voltage or a direct pulse voltage. As to the voltage to be applied, it is preferred that the voltage is 20 V, and the current is 100 A or more. This is because when the current is less than 100 A, the amount of generated carbon nanomaterial is reduced. It is more preferred that the voltage is a direct voltage, and the current is 140 A or more.

Furthermore, by using the graphite anode in which an anode contains graphite, the electrode and a carbon material can be integrated. Thus, the configuration of the device can be easily designed. Moreover, in this case, it is preferred that arc discharge is generated by applying a voltage in the state where the electrode cross-sectional area of cathode is greater than the cross-sectional area of graphite anode. Therefore, energy profiles in a region in which arc discharge is generated can be controlled, and the generated carbon nanomaterial can be prevented from being again vaporized. It is preferred that the cross-sectional surface area of the negative electrode 24 be larger than that of the graphite positive electrode 22. In such a case, the produced carbon nanomaterial can be prevented from evaporating again. It is more preferred that the cross-sectional surface area of the negative electrode 24 be 1.5 times or more the cross-sectional surface area of the graphite positive electrode 22. Further, it is preferred that the gap between the graphite positive electrode 22 and the negative electrode 24 be from 1 mm to 2 mm. By setting the gap S within such a range, it is possible to generate the arc discharge efficiently. This is because where the gap is less than 1 mm or greater than 2 mm, the arc discharge becomes unstable. In order to maintain the gap S between the graphite positive electrode and the negative electrode within a range from 1 mm to 2 mm, it is preferred that a support section supporting the negative electrode or a support section supporting the graphite positive electrode be disposed drivably. It is even more preferred that the gap S between the graphite positive electrode and the negative electrode be adjustable. This is because the graphite positive electrode is consumed by the arc discharge with the passage of time and the gap S between the graphite positive electrode and the negative electrode opens, thereby making the arc discharge unstable.

It is preferred that the arc discharge is generated in a fluid or in the vicinity of the fluid. Therefore, a carbon vapor generated by the arc discharge can be promptly cooled in the fluid, and a carbon nanomaterial can be generated. In order to achieve this, it is preferred that electrodes are arranged so that a space between the electrodes that face each other is in a fluid, and an introduction path and the like of inert gas is configured so that the fluid or the vaporized fluid is not completely excluded from the space in arc discharge. Moreover, the fluid can transfer the generated carbon nanomaterial. In the present description, "fluid" means a substance having fluidity by stirring. Specifically, the fluid is preferably a liquid medium having fluidity by stirring at a temperature at or below which arc discharge is generated. For example, according to a liquid medium having fluidity by stirring at a temperature at or below which arc discharge is generated, water, a mixed liquid containing water, silicone oil, oil, an aqueous solution, liquid helium, liquid nitrogen, or the like can be used. Among them, water is favorable because water is inexpensive and easily available and easy to handle. Moreover, a water medium under arc discharge has a cluster structure that is smaller than that of water in the normal state, and a redox potential of a water medium can be increased. The reduction in cluster structure and the increase in redox potential of a water medium can accelerate formation of carbon nanomaterial.

FIGS. 1A and 1B show a device for producing a carbon nanomaterial, specifically a production device suitable for production of carbon nanohorns, being an embodiment of the present teaching. As shown in FIG. 1A, in a fluid bath 10, a graphite anode 12 and a cathode 14 are provided so as to face each other via a gap 34. Although the shapes and the arrangements of the cathode 14 and the graphite anode 12 are not limited, it is favorable that they are arranged to vertically face each other because a fluid can be stirred easily by rotating the cathode 14 as described below, and arc discharge becomes stable. Further, the fluid bath 10 is formed so as to store a fluid 20, and a container made of glass, ceramics, a metal, a resin, or the like can be used. The fluid bath 10 may be a container having a heat-insulated structure. Further, it is preferred that the fluid bath 10 can be made airtight. In order to make the fluid bath airtight, the fluid bath may be provided with a lid 11, for example. This is because when the fluid bath can be made airtight, a pressure in the fluid bath is increased by introducing inert gas, and generation of carbon nanomaterial is accelerated under the high-pressure condition. That is, when the fluid bath is an airtight bath, energy profiles in the region in which arc discharge is generated can be controlled. When the fluid bath can be made airtight, the device may further be provided with a mechanism or adjusting a pressure in the fluid bath. For example, the device is preferably provided with a pressure adjustment valve for pressure adjustment device for adjusting a pressure in the fluid bath. Thus, a pressure in the fluid bath can be controlled, and energy profiles in the region in which arc discharge is generated can be controlled. Moreover, when the graphite anode 12 is connected to a positive electrode 26 of a power source 22, and the cathode 14 is connected to a negative electrode 24 of the power source 22, a voltage can be applied between the graphite anode 12 and the cathode 14. At that time, insulation breakage of gas or liquid presented in a gap 34 is generated by a potential difference between the electrodes, and electrons can flow (discharge) in the gap 34.

It is preferred that the end part of the cathode 14 and the end part of the graphite anode 12, facing each other, are exposed to the fluid 20. Although the gap 34 formed between the end parts is the region in which arc discharge is generated, the region in which arc discharge is generated is formed in the fluid 20 because the end parts are exposed to the fluid 20.

As shown in FIG. 1(b), an outer wall 42 that forms a compartment so as to surround the gap 34 which is arc discharge generating region. In the present embodiment, the outer wall 42 has a substantially cylindrical shape enclosing the outer circumference of the negative electrode 14. As a result, the directivity of the discharge towards the vicinity of the graphite positive electrode 12 can be increased, and the arc discharge can be generated more effectively. Further, the outer wall 42 may be connected to a drive unit for enabling the positional adjustment of the outer wall 42. By enabling the positional adjustment of the outer wall 42, it is possible to change the directivity of the inert gas with respect to the gap34 and better control the energy profile of the arc discharge generation region. Thus, the amount of produced carbon nanomaterial can be controlled. The outer wall 42 can be made using a well-known material, for example, metals, ceramics, tungsten, or graphite, but using graphite, iron, and aluminum, which are electrically conductive, is preferred. The best option is to use graphite, which has high electronegativity, for the outer wall 42. Where graphite is used for the outer wall 42, the amount of electrons emitted into the compartment when a voltage is applied between the electrodes is increased and the temperature of the gap 34 rises efficiently. Where depressions and protrusions are provided on the inner surface of the outer wall 42, the surface area is increased, thereby advantageously increasing the amount of electrons emitted into the compartment and stabilizing the generated arc discharge.

### (Step of introducing inert gas)

The step of introducing inert gas in the present embodiment can be a step of introducing inert gas to a region in which arc discharge is generated in a fluid. According to this step, electron discharge from a cathode and temporal generation of intermediate of carbon nanomaterial in the region in which arc discharge is generated can be accelerated. By introducing inert gas into the region in which arc discharge is generated, the inert gas is partially dissociated, and charged particles are generated. These charged particles enhance an electrical conductivity of the region in which arc discharge is generated and can cause discharge to be easily generated. Moreover, the inert gas is heated by the arc discharge, and molecular vibrational excitation, dissociation, and ionization are progressed. Thus, the plasma state is formed. The inert gas with high enthalpy under the energy profiles in such active state is expanded, energy for propulsion can be obtained by Joule heating, and a large amount of graphite vapor can be generated by accelerating electron emission from the cathode.

Furthermore, by introducing the inert gas in the fluid into the region in which arc discharge is generated, the carbon vapor generated by the arc discharge can be taken in the inert gas and can be diffused in the fluid other than the region in which arc discharge is generated. While the inert gas is diffused in water in the frothy state, the carbon vapor contained in the inner gas is rapidly cooled in the fluid. Thus, a carbon nanomaterial can be generated. The carbon nanomaterial generated at that time is floated in the vicinity of the surface of the fluid. The carbon nanomaterial is not returned in the region in which arc discharge is generated. Thus, it is avoided that the carbon nanomaterial is again carbon-vaporized. The carbon nanomaterial and the intermediate thereof, generated in the region in which arc discharge is generated, are also taken in the inert gas, diffused in the fluid other than the region in which arc discharge is generated, and floated on the surface of the fluid as the carbon nanomaterial. Thus, it is avoided that the carbon nanomaterial is again carbon-vaporized. These results show that it can be suppressed that the carbon nanomaterial once generated from the carbon vapor is again vaporized to be a carbon vapor, and the yield of the carbon nanomaterial can be enhanced.

Moreover, according to the disclosure of the present description, it is preferred that a carbon vapor is generated from a carbon material provided in the region in which arc discharge is generated under pressure of fluid. In order to pressurize a fluid, when the fluid is made airtight so as to be in the state in which the fluid can be pressurized by making the fluid bath in the airtight state, for example, the pressure in the fluid bath is increased by introducing inert gas into the fluid bath, and the fluid can be in the high-pressure condition. Under such pressure on fluid, by rapidly cooling of carbon vapor and acceleration of self-assembly of carbon vapor, a carbon nanomaterial can be effectively generated. Furthermore, according to arc discharge under pressure on fluid, the fluid can be actively caused to be present in or close to the region in which arc discharge is generated or the vicinity thereof. Therefore, in the case where the region in which arc discharge is generated and the fluid cannot be substantially present, a carbon vapor rapidly contacts with the fluid and is cooled when the fluid is pressurized.

A carbon nanomaterial generated by cooling the carbon vapor is adhered to and deposited on the graphite anode. A part of the adhered and deposited carbon nanomaterial is removed from a partition by a pressure received from arc discharge and a fluid pressure of the introduced inert gas and is precipitated and deposited in the fluid. Thus, the part of the adhered and deposited carbon nanomaterial is separated from the carbon nanomaterial floated on the surface of the fluid.

Moreover, by controlling the flow rate and the flow path of the inert gas introduced into the region in which arc discharge is generated, the size of the region in which arc discharge is generated and the energy profiles such as, for example, the quantity of electron to be discharged and the pressure at which discharge is performed, of the region in which arc discharge is generated can be controlled. Therefore, by introducing the inert gas at a predetermined flow rate into the vicinity of the graphite anode, a heated region and the heating temperature by arc discharge can be controlled. Therefore, the carbon vapor can be effectively generated. The above-described predetermined flow rate of the inert gas of 15 litters or more per 1 minute is preferable because a carbon nanomaterial can be efficiently generated. The flow rate of the inert gas of 20 litters or more to 25 litters or less per 1 minute is more favorable. When the flow rate is less than 20 litters, a reaction occurs only between the electrodes, and the yield of the carbon nanomaterial is reduced. When the flow rate is more than 25 litters, excessive nitrogen gas is generated, air bubbles each containing the carbon nanomaterial are floated on the water and are prone to be discharged into air.

As shown in FIG. 1A, as a method for introducing the inert gas into the gap 34 that is the region in which arc discharge is generated, for example, a method of introducing the inert gas into the gap 34 from a cylinder 28 through a supply path 16 can be employed. In order to suppress adhesion of a substance to the electrodes to certainly diffuse the generated carbon vapor and the like in the fluid other than the region in which arc discharge is generated, it is preferred that inert gas is previously introduced prior to the generation of arc discharge.

The "inert gas", as referred to in the present description, is a gas with poor chemical reactivity. Examples of the inert gases include elements of the 18th group (rare gases) constituted by helium, neon, argon, krypton, xenon, and radon, hydrazine, nitrogen gas, carbon dioxide, hydrogen gas, or mixtures thereof. Among them nitrogen gas is preferred because it is inexpensive and easy to procure. The inert gas can be stored as gas, or may be acquired as a liquid, or may be acquired as a solid, provided that it can be introduced as gas into the arc discharge generation region. The inactive substance of such a kind can be acquired, as appropriate, by a person skilled in the art by referring to the conventional techniques.

In order to remove the impurity that has adhered to the electrodes as a result of arc discharge, it is possible, for example, to generate the arc discharge in a state in which the cross-sectional surface area of the negative electrode 24 is larger than the cross-sectional area of the graphite positive electrode, whereby a propulsion force is obtained as a Lorentz force in the arc discharge generation region and the impurity strongly attached to the electrodes or partition wall can be peeled off by a jet Further, the flow pressure of the inert gas introduced into the arc discharge generation region 30 may be also used, or the aqueous medium W may be stirred by causing rotational vibrations of either or both of the graphite positive electrode and the negative electrode in order to remove the impurity or generated carbon nanomaterial that has adhered to the electrodes.

As shown in FIG. 1(a), rotation devices 36, 38 may be disposed correspondingly to the negative electrode 14 and the graphite positive electrode 12 to enable the rotation thereof. The rotation device 36 can rotate the negative electrode 14 continuously or intermittently, and the rotation device 38 can rotate the graphite positive electrode 12 continuously or intermittently. The rotation can be also performed in a state in which the angles of the negative electrode 14 and the graphite positive electrode 12 have been adjusted. For example, the arrangement may be such as to enable the rotation of the electrodes in a state in which the electrodes are inclined in the long axis direction thereof, for example, at an angle of about, for example, 0.5 degree or 1 degree with respect to the vertical direction. As a result, the electrodes can be rotated while being subjected to vibrations, thereby making it possible to effectively prevent the carbon nanoparticles from deposition or remove the deposited carbon nanoparticles. Further, when the electrodes are rotated in the inclined state thereof, it is preferred that the rotational movement be executed for removing the deposits after the arc discharge, rather than during the arc discharge, in order not to impede the air discharge stability.

The fluid can be stirred using not only the graphite anode or the cathode, but also a stirrer. Favorably, it is preferred that in the state where the electrode cross-sectional area of the cathode is greater than the cross-sectional area of the graphite anode, the carbon vapor is introduced into the fluid on the basis of the fluid pressure of inert gas while the graphite anode and the cathode are rotated and vibrated. Moreover, it is preferred that inert gas is introduced prior to the generation of the arc discharge.

In order to prevent the generated carbon nanomaterial to be again vaporized, the arc discharge can be stopped while the carbon vapor is introduced into the fluid together with the inert gas. Moreover, even in the case where the arc discharge is stopped, the inert gas can be continuously introduced in order to remove the carbon nanomaterial adhered to the electrodes. Similarly, the cathode may be continuously rotated and vibrated. Thus, the carbon nanomaterial introduced into the fluid can be dispersed, and the carbon nanomaterial can be prevented from being aggregated and adhered to the fluid bath and electrodes. Thus, a large amount of carbon nanomaterial can be obtained.

As shown in FIG. 1A, as a method for introducing the carbon vapor into the fluid other than the region in which arc discharge is generated together with the inert gas, a method for designing the electrode cross-sectional area of the cathode 14 to be greater than the cross-sectional area of the graphite anode 12 can be employed. A method for introducing inert gas into the gap 34 that is the region in which arc discharge is generated from the cylinder 28 via the supply path 16 can also be employed. A support 18 supporting the cathode 14 can be designed so as to rotationally move in the horizontal direction. Furthermore, the support 18 can support the supply path 16 for supplying inert gas introduced from the cylinder 28 to the gap 34 that is the region in which arc discharge is generated. That is, while inert gas is supplied to the region in which arc discharge is generated, the inert gas can be diffused into the fluid other than the region in which arc discharge is generated.

As shown in FIG. 2(a), the device can be provided with one, or two or more supply paths 40 passing through inside the negative electrode 14 in order to supply the inert gas efficiently to the vicinity of the negative electrode 14. For example, the supply path 40 may be in the form of one, or two or more vent grooves formed at the outer circumferential side of the negative electrode 14, as shown in FIG. 2(b). Further, each of the introduction paths 40 shown in these figures may not be formed vertically. The introducing path 40 may be formed in a spiral shape passing along the outer circumference of the negative electrode 14 or thereinside. It is preferred that the negative electrode 14 be arranged vertically in relation to the gravity force direction and be provided with a spiral introducing path 40, since the inert gas can be stably introduced as a swirling flow into the arc discharge generation region, and plasma can be confined to the swirl center by the pinch effect created by the arc discharge. Moreover, it is preferred that a wall (reaction wall) is provided around each of the gap 34 that is the region in which arc discharge is generated, the cathode 14, and the graphite anode 12 because a reduction of change in shape of each electrode by the carbon vapor at high temperature can be obtained. Although three grooves or holes are shown in the cathode 14 as introduction paths 40 in FIGS. 2A and 2B, the number of the introduction paths 40 may be one or more. When the supply paths 40 are formed, the shape of the negative electrode 24 and the shape and number of the introducing paths 40 are not limited and can be changed, as appropriate, within a design range.

By repeatedly performing generation of arc discharge, a carbon vapor at high temperature is continuously generated. Thus, there is a possibility that the temperature of the fluid is increased when the amount of the fluid is small. By the increase in temperature of the fluid, the carbon vapor cannot be rapidly cooled, and there is a possibility that the amount of the generated carbon nanomaterial is reduced, or a defect is generated in the structure of the carbon nanomaterial. Therefore, it is preferred to include a step of adjusting the temperature of the fluid. For example, in order to maintain the temperature of the fluid to a constant temperature, the device can include a cooling mechanism, the cooling time can be provided, the fluid can be supplemented or replaced, or a fluid at low temperature containing liquid nitrogen can be used. Moreover, in order to prevent the temperature of the fluid from being locally increased at a part of introducing the carbon vapor, a step of stirring the fluid in the fluid bath can be included. When the fluid in the fluid bath is stirred, the graphite anode and the cathode may be designed so as to move rotationally so that the fluid can be stirred by the electrodes, the fluid may be stirred using a fluid pressure of the inert gas, or a stirrer may be used. Those skilled in the art can obtain such method for controlling the temperature of the fluid with reference to conventional art as appropriate.

The step of collecting the carbon nanomaterial generated by the step of generating arc discharge and the step of introducing inert gas into a region in which arc discharge is generated is described in detail below.

### (Step of collecting carbon nanomaterial)

The step of collecting the carbon nanomaterial in the present embodiment is a step of collecting the carbon nanomaterial generated by rapidly cooling the carbon vapor. In the present step, although the carbon nanomaterial may be collected from the entire fluid after generation of the carbon nanomaterial, a fluid fraction containing the carbon nanomaterial in the fluid is aspirated, and the carbon nanomaterial and the fluid may be separated by solid-liquid separation means. In this case, the fluid fraction represents a part of the fluid. For example, a part of the fluid is aspirated to collect the carbon nanomaterial, and again returning the remaining fluid to the fluid bath may be repeated. According to the above-described method, a fraction containing the carbon nanomaterial in the fluid can be selectively aspirated, and thus, it is not required to take entire fluid in the fluid bath out. That is, an operation from the generation of arc discharge to the collection of the carbon nanomaterial can be continuously performed. Accordingly, complicated operations are not required, and a large amount of the carbon nanomaterial can be produced.

The fluid fraction containing the carbon nanomaterial can be a fluid in the vicinity of the surface of the fluid. The fluid fraction contains the floating carbon nanomaterial, and a single-layer carbon nanomaterial can be obtained from the fraction. The fluid faction can be an intermediate fluid fraction between fluid the surface and the bottom. This fluid fraction also contains the floating carbon nanomaterial, and single-layer nanocarbon particles can be obtained. The fluid fraction can be a fluid fraction in the vicinity of the bottom of the fluid bath. The fluid fraction contains the precipitated and deposited carbon nanomaterial, and multi-layer carbon nanomaterial can be obtained from the fraction. That is, by selecting the fluid fraction to be aspirated, i.e., selecting a part to be aspirated in the fluid bath, a single-layer carbon nanomaterials and multi-layer carbon nanomaterial can be separated and obtained efficiently. Specifically, the single-layer carbon nanohorns can be obtained from the floating carbon nanomaterial, and the multi-layer carbon nanohorns can be obtained from the precipitated and deposited carbon nanomaterial.

The solid-liquid separation means is not particularly limited, and known means such as filtration or centrifugal separation can be used. In the present method, the carbon nanomaterial is floated or precipitated. Thus, it is preferred that the solid-liquid separation is performed by filtration. A method of the filtration may be a method using a membrane filter or a method utilizing absorption. Moreover, the method of the filtration may be hot filtration in which the carbon nanomaterial is taken out by vaporizing the fluid. As the filtration using a membrane filter, filtration under reduced pressure, filtration under pressure, and centrifugal filtration can be used in addition to natural filtration by gravity. As a membrane filter, a filter paper, cellulose, a glass fiber filter, a membrane filter, a filtration plate, a cotton plug, sand, and the like can be used. Specifically, using a ultrafiltration membrane method (UF method) that can allow a fluid concentrated by fine particles and impurities to pass through continuously is preferable. Moreover, in the case where the carbon nanomaterial is purified by the UF method, multiple membrane filters according to the particle diameter (e.g., a hollow fiber membrane) may be used. By using multiple membrane filters according to the particle diameter, the carbon nanomaterial can be easily subjected to fraction separation and purified according to the particle diameter.

Furthermore, by drying the separated carbon nanomaterial, the carbon nanomaterial can be obtained. The carbon nanomaterial in the fluid may be dried as part of implementing a step of the solid-liquid separation, or dried separately after the solid-liquid separation. The drying method is not particularly limited, and any of various known methods can be employed. For example, the method may be a method in which the fluid is vaporized under the high-temperature condition, a method utilizing vacuum, or a method in which the fluid is placed in gas containing moisture at the amount of saturated vapor or less to remove water in the fluid. Moreover, the water in the fluid may be removed by a chemical reaction. In the present embodiment, the carbon nanomaterial is purified by drying. Thus, considering thermal denaturation and chemical denaturation, using spray drying is preferable.

As shown in FIG. 1A, for example, the device can be configured so that the tip of an aspiration tube 32 connected to a filter 30 is configured so as to be immersed in the fluid 20. With the tip of the aspiration tube 32 being arranged in the flow of the fluid 20 or in the vicinity of the fluid surface, the floating carbon nanomaterial can be aspirated on the filter 30. By designing the aspiration tube 32 so as to be expandable and shrinkable vertically and placing the tip of the aspiration tube 32 in the vicinity of the bottom surface of the fluid bath 10, the precipitated and deposited carbon nanomaterial may be aspirated. The aspirated carbon nanomaterial can be separated from the fluid by the filter 30. Subsequently, the carbon nanomaterial separated from the fluid is dried by spray drying. Thus, the purified carbon nanomaterial can be obtained.

The device for producing carbon nanomaterial is not limited to the embodiment shown in FIGS. 1A and 1B, and any of the various embodiments can be employed. FIG. 3 shows a device for producing a carbon nanomaterial, of another embodiment. In this embodiment, an outer wall 42a is formed around the cathode 14 of FIGS. 1A and 1B, and the descriptions of the identical members to those shown in FIGS. 1A and 1B are omitted. The device shown in FIG. 3 has the outer wall 42a on the outside of a support 18 supporting the cathode 14 at a distance, and a supply path 16b for introducing inert gas is formed between the support 18 and the outer wall 42a. The outer wall 42a has a substantially cylindrical shape surrounding the outer periphery of the cathode 14 in the present embodiment. Thus, the supply path 16b inside the outer wall 42a is shielded from outside of the outer wall 42a, and inert gas can flow in only the supply path 16b. Inert gas can be introduced into the supply path 16b. By providing the device with the outer wall 42a to regulate the flow of the inert gas in the fluid, the directional characteristics of the inert gas introduced into the supply path 16b in generation of arc discharge to the vicinity of the graphite anode 12 are enhanced, and the inert gas can effectively reach the vicinity of the graphite anode 12. Therefore, unintended or random dispersion and diffusion of air bubbles can be suppressed, and diffusion of the carbon nanomaterial caused by moving the air bubbles up to the liquid level can be avoided. Thus, the carbon nanomaterial can be collected easily, or the collection rate can be improved. Moreover, by appropriately changing the shape of the lower part of the outer wall 42a, i.e., the shape of the vicinity of the outlet of the inert gas according to the shape and the arrangement of the electrode and the like, the directional characteristics of the inert gas to the vicinity of the electrode and the arrival state of the inert gas at the vicinity of the electrode can be adjusted. For example, the vicinity of the outlet can be formed so as to expand toward the outlet side or so as to direct toward the vertically lower side. The shape of the vicinity of the outlet can be changed as appropriate if necessary. As described above, by providing the device with the outer wall 42a, the distribution state of the inert gas can be adjusted, the directional characteristics to the graphite anode 12 or the like, the arrival state, the amount of the carbon nanomaterial to be generated, and the yield of the carbon nanomaterial can be optimized.

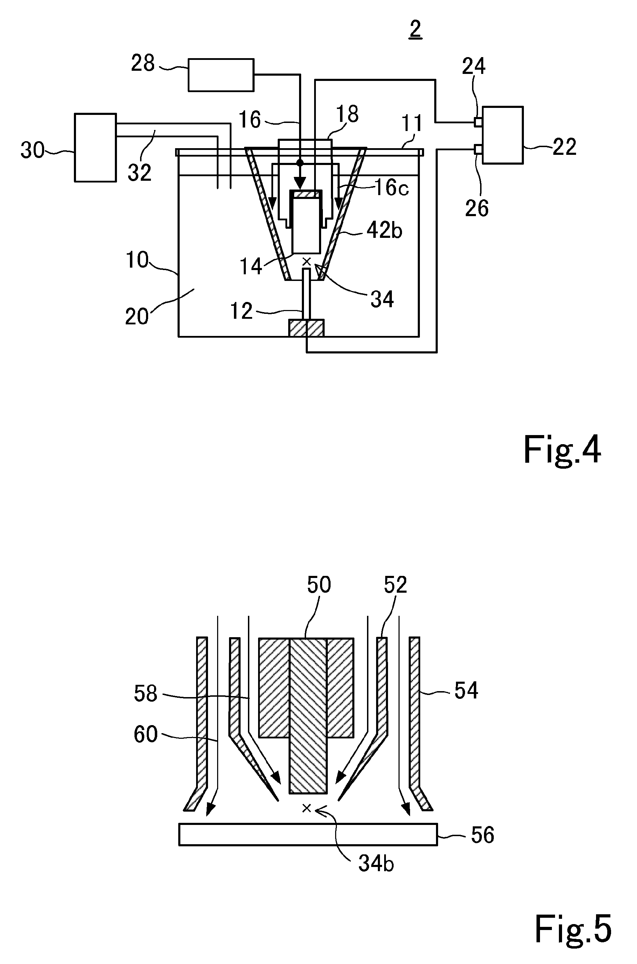

FIG. 4 shows a device for producing a carbon nanomaterial, of yet another embodiment. In the present embodiment, an outer wall 42b is formed so as to encompass from the cathode 14 to the tip of the graphite anode 12 shown in FIGS. 1A and 1B. The descriptions of the identical members to those shown in FIGS. 1A and 1B are omitted. The device shown in FIG. 4 has the outer wall 42b on the outside of a support 18 supporting the cathode 14 at a distance, and a supply path 16c for introducing inert gas is formed between the support 18 and the outer wall 42b. Inert gas can be introduced into the supply path 16c. Although the inert gas outlet side of the outer wall 42b can be arranged at any height, the lower part thereof (the end edge on the outlet side) may be extended so as to encompass the tip of the graphite anode 12. For example, in the embodiment shown in FIG. 4, the outer wall 42b is arranged so as to encompass the gap 34 that is the region in which arc discharge is generated. Moreover, the shape of the outer wall 42b has a hollow truncated conical shape so that the enclosed inner shape becomes small toward a lower part. Moreover, at least the inside of the outer wall 42b may be groove-processed so as to have a helical shape. Therefore, for example, a helical groove may be provided inside by forming the outer wall 42b itself into an accordion shape. In generation of arc discharge, when the inert gas is helically dispersed and sprayed in the supply path 16c, a rotating field can be generated by a rotation air effect of the inert gas. The rotating field can be easily generated by rotating the electrodes as described above. At that time, the rotating field can be controlled by the amount of the inert gas to be supplied and the number of rotations of the electrodes, and the shape of plasma can be variably controlled. Thus, energy profiles of the region in which arc discharge is generated can be controlled, and a carbon nanomaterial can be efficiently synthesized.

FIG. 5 shows a device for producing a carbon nanomaterial, of yet another embodiment. The device of the present embodiment produces a carbon nanomaterial without using a graphite anode. For example, for both of the electrodes, electrode materials such as tungsten, ceramics, and molybdenum can be used. As shown in FIG. 5, the device of the present embodiment includes an anode 50 and a cathode 52 that encompasses the anode 50 and has a nozzle portion that converges to taper toward a region that is little beyond the tip (lower end) of the anode 50. The region that is little beyond the tip of the anode 50 is intended to be the region in which arc discharge is generated. A supply path 58 for inert gas is formed between the anode 50 and the cathode 52 enclosing the anode 50. Moreover, an outer wall 54 may be formed so as to encompass the surrounding of the cathode 52. Furthermore, a supply path 60 for inert gas may be formed between the outer wall 54 and the cathode 52.

A graphite plate 56 is arranged at the lower parts of the electrodes 50 and 52 at a predetermined distance. A gap 34b between the electrodes 50 and 52 and the graphite plate 56 is the region in which arc discharge is generated. Although the distance between the graphite plate 56 and the anode 50 is not particularly limited as long as it is in a range in which a carbon vapor can be formed by applying a voltage between the anode 50 and the cathode 52, it can be, for example, about 5 mm. According to the device of the present embodiment, defects in arc discharge, caused by the wearing out of the electrodes and impurities deposited on the electrodes, are reduced compared with the case of using a graphite anode, and a large amount of carbon nanomaterial can be synthesized more stably. Moreover, by using a low-cost graphite plate, the costs involved in generation of the carbon nanomaterial can be reduced. The anode 50 and the cathode 52 of the present embodiment are not required to face each other in a direction vertical to gravity and may be provided with various directional characteristics.

As described above, according to the method for producing a carbon nanomaterial, disclosed in the present description, the step of forming a region in which arc discharge is generated between electrodes by applying a voltage between a cathode and an anode arranged in a fluid and the step of generating a carbon vapor from a carbon material provided in the region in which arc discharge is generated under pressure on the fluid and introducing inert gas into the region in which arc discharge is generated can be included. Moreover, the cathode may be arranged so as to face the anode. Furthermore, as the anode, a graphite anode can be used. Further, as the fluid, a liquid medium containing water and having fluidity by stirring at or below a temperature at which arc discharge is generated. Furthermore, a carbon nanomaterial floating in the fluid may be a single-layer carbon nanohorn.

Moreover, the arc discharge can be generated by applying a direct voltage or a direct pulse voltage to the electrode. Furthermore, the arc discharge can be generated by applying a voltage in the state where the electrode cross-sectional area of the cathode is greater than the electrode cross-sectional area of the graphite anode. Moreover, the graphite anode may contain or store additives, or additives are sprayed, applied, plated, or coated on a part of the surface of the graphite anode or the entire graphite anode. Furthermore, the production method may further include a step of applying a rotational vibration in the horizontal direction by the graphite cathode. The production method may further include a step of dispersing a carbon nanomaterial sent out into the fluid, a step of stirring the fluid in the fluid bath in order to prevent the temperature of the fluid from being locally increased at a part of introducing the carbon vapor, and a step of adjusting the temperature of the fluid in order to maintain the temperature of the fluid to a constant temperature. The graphite anode and the cathode may be arranged so as to face each other in a direction vertical to gravity. The production method may further include a step of collecting the carbon nanomaterial generated from the carbon vapor from the fluid.

The step of collecting the carbon nanomaterial may include a step of aspirating the fluid containing the carbon nanomaterial, a step of separating the carbon nanomaterial from the fluid using a membrane filter, and a step of drying the separated carbon nanomaterial.

The inert gas may be a gas containing one or more kinds selected from the group consisting of noble gases including nitrogen, argon, helium, and hydrazine. Further, the carbon nanomaterial floating in the fluid may be a single-layer carbon nanohorn. The arc discharge may be generated by applying a direct voltage or a direct pulse voltage to the electrodes. Furthermore, the arc discharge may be generated by applying a voltage in the state where the electrode cross-sectional area of the cathode is greater than the electrode cross-sectional area of the graphite anode. Moreover, the graphite anode may contain or store additives, or additives are sprayed, applied, plated, or coated on a part of the surface of the graphite anode or the entire graphite anode. Furthermore, the production method may further include a step of applying a rotational vibration in the horizontal direction by the graphite cathode. The production method may further include a step of dispersing a carbon nanomaterial sent out into the fluid and a step of stirring the fluid in the fluid bath in order to prevent the temperature of the fluid from being locally increased at a part of introducing the carbon vapor. The production method may further include a step of adjusting the temperature of the fluid in order to maintain the temperature of the fluid to a constant temperature. The graphite anode and the cathode may be arranged so as to face each other in a direction vertical to gravity. The production method may further include a step of collecting the carbon nanomaterial generated from the carbon vapor from the fluid. Moreover, the step of collecting the carbon nanomaterial may further include a step of aspirating a fluid containing the carbon nanomaterial, a step of separating the carbon nanomaterial from the fluid using a membrane filter, and a step of drying the separated carbon nanomaterial.

The device for producing a carbon nanomaterial, disclosed in the present description, can include a cathode partially immersed in a fluid, a cathode arranged in the fluid at a distance at a part of the cathode immersed in the fluid, a mechanism of applying a voltage between the cathode and the anode and forming the region in which arc discharge is generated, and a mechanism of introducing inert gas into the region in which arc discharge is generated.

The anode is a graphite anode and may be arranged so as to face the cathode.

A gap between the graphite anode and the cathode may be 1 mm or more to 2 mm or less.

The cathode can be rotated and vibrated in a horizontal direction.

The mechanism of collecting the carbon nanomaterial may include a mechanism of aspirating the fluid containing the carbon nanomaterial, a mechanism of separating the carbon nanomaterial from the fluid, and a mechanism of drying the separated carbon nanomaterial.

The cathode can have an introduction path for the inert gas.

### (Production method of dense material of the present teaching)

For example, the method for producing a dense material of the present teaching includes: providing a molding material containing a carbon nanohorn produced by arc discharge in a fluid, described above; and heating and molding the molding material under pressure to produce the dense material according to the present teaching.

According to this production method, a dense molding of carbon nanohorn or a complex of carbon nanohorn and other materials can be effectively produced.

### (Provision of molding material)

A molding material is produced using carbon nanohorn. Specifically, only a carbon nanohorn of the present teaching is substantially used, or the carbon nanohorn of the present teaching is mixed with other materials, to obtain a molding material. The carbon nanohorn of the present teaching has no shape anisotropy and has appropriate hydrophilicity, favorable miscibility, and appropriate binding properties. Furthermore, the carbon nanohorn of the present teaching has uniform dispersibility and affinity with other materials. Therefore, a molding material that is suitable for molding can be provided. Moreover, it is easy to provide a molding material.

The molding material containing other materials in addition to a carbon nanohorn can be produced by mixing a carbon nanohorn and other materials in a dry system or a wet system. In the case of the dry system, a known dry mixing device such as ball mill can be used, and in the case of the wet system, a known wet mixing device using an appropriate medium can be used. A mixed solvent in the wet system may be an aqueous medium or non-aqueous medium. However, favorable miscibility with other materials can be obtained in many cases, and cost problems and environmental problems can be reduced by using an aqueous medium. By using the carbon nanohorn disclosed in the present description, i.e., the carbon nanohorn of the present teaching, mixing in an aqueous medium can be easily achieved. Moreover, by using a hydrophobic medium, favorable miscibility can be achieved. In the case of the wet system, after sufficient mixing, a molding material in a slurry form can be obtained, and a solid molding material may be obtained by drying the slurry.

For formation of a composite of the carbon nanohorn and other materials, known materials can be used as the other materials. Examples of the other materials include inorganic materials. For example, examples of the other materials include various ceramics materials, metallic materials, and glass materials.

These other materials is preferably used after controlling a particle diameter and the like considering miscibility with the carbon nanohorn.

In the molding material that contains other materials, the amount of the carbon nanohorrn can be decided as appropriate. For example, the content of the carbon nanohorn can be 0.1% by mass or more to 99.9% by mass or less. The content of the carbon nanohorn can be decided as appropriate according to the use and the required characteristics of the molding material.

The ceramics material is not particularly limited, and examples thereof include complex oxide ceramics, nitrogen ceramics, and carbide ceramics in addition to typical oxide ceramics such as alumina, ceria, zirconia, and magnesia.

The glass material is not particularly limited, and examples thereof include soda glass, lead crystal glass, borosilicate glass (heat - resistant glass), superheat-resistant glass, float glass, tempered glass, frost glass, figured glass, Saint-Gobain glass , colored antique, mirror, heat-absorbing glass, antireflection-treated glass (non-glare S), low-reflection glass, high-transmission glass, heat-resistant glass plate, wire glass, checker glass, mol glass, ceramic-printed glass, and stained glass-like decorative glass.

The metallic material is not particularly limited, and examples thereof include gold, silver, platinum, palladium, rhodium, iridium, ruthenium, osmium, non-metal, alkali metal, alkali earth metal, aluminum, and zinc.

Such molding material is heated under pressure to give a three-dimensional shape. In such heating under pressure, a known sintering device used in molding of general ceramics can be selected and used as appropriate. For example, spark plasma sintering can be used.

The pressurizing condition and the heating condition to obtain the dense material of the present teaching can be decided as appropriate. For example, the pressurizing condition is preferably 15 kN, more preferably 20 kN or more. With such pressurizing condition, a dense molding with 1.0g/cm3 or more can be obtained even in the case of using only a carbon nanohorn with a high density. The upper limit of the pressurizing condition can be set as appropriate, and is preferably 50 kN or less or 40 kN. The heating temperature can also be set as appropriate and is, however, preferably 1000°C or more, more preferably 1200°C or more, yet more preferably 1400°C. In the case where only carbon nanohorn is used, the heating temperature is preferably 1800°C or more, more preferably about 2000°C.

### (Dense material of the present teaching)

The dense material of the present teaching is a dense composite material containing carbon nanohorns with hydrophilicity and having a predetermined three-dimensional shape. The dense material of the present teaching is characterized by features of carbon nanohorns to be used and features of other composite materials, exhibits characteristics of being dense, and can be used in various uses.

The density of the dense material of the present teaching can be typically 1.0 g/cm3 or more. This density can be achieved by only the carbon nanohorn. In the case where the density is achieved by only the carbon nanohorn, the density of the dense material is preferably 1.1 g/cm3 or more, more preferably 1.2 g/cm3 or more. In the case where the density is achieved by a composite material with other materials, the amount of the dense material composed of only other materials can be generally reduced although it depends on the specific gravities of various other materials to a ceramics material, a metallic material, and a glass material and the amount of carbon nanohorns to be added.

The carbon nanohorns used in the present teaching can have the following characteristics:
(1) Pore volume of 0.8 cm3/g or more;
(2) Relating to one or more elements selected from the group consisting of Na, K, Mg, Ca, Fe, Si, and Cl and contains the one or more elements in the following contents;
(3) Na: 0.003% or more to 0.3% or less;
   K: 0.001 % or more to 0.1 % or less;
   Mg: 0.0005% or more to 0.05% or less;
   Ca: 0.004% or more to 0.4% or less;
   Fe: 0.006% or more to 0.6% or less;
   Si: 0.002% or more to 0.2% or less; and
   Cl: 0.004% or more to 0.4% or less;
(4) Mainly composed of carbon nanohorns each with a length of 30 mm or less; and
(5) Supporting various metals such as tungsten, platinum, titanium, cobalt, nickel, and manganese.

The dense material of the present teaching can have favorable characteristics of electromagnetic wave shield. Considering the characteristics of electromagnetic wave shield, the content of the carbon nanohorn of the present teaching is preferably high. Although the content is not particularly limited, it is, for example, preferably 3% or more, more preferably 5% or more, yet more preferably 10% or more, yet more preferably 15% or more, yet more preferably 20% or more, yet more preferably 25% or more. Further, the content is yet more preferably 25% or more, yet more preferably 30% or more, yet more preferably 35% or more. Furthermore, the content is yet more preferably 40% or more, yet more preferably 45% or more, yet more preferably 50% or more. Moreover, the content is yet more preferably 55% or more, yet more preferably 60% or more, yet more preferably 65% or more. Moreover, the content is yet more preferably 70% or more, yet more preferably 75% or more, yet more preferably 80% or more. Moreover, the content is yet more preferably 85% or more, yet more preferably 90% or more, yet more preferably 95% or more, yet more preferably 98% or more, yet more preferably 99% or more.

A sheet-like molding, for example, containing 99% or more, preferably 99.5% or more carbon nanohorn of the present teaching and having a thickness of about 1 mm (about 0.8 mm or more to about 1.2 mm or less) can exert an electromagnetic wave shield effect of more than 30 dB, preferably 40 dB or more in a broad frequency range (0.1 MHz or more to 1000 MHz or less), a long wave (LF, 100 KHz or more to 300 KHz or less), a medium wave (MF, 0.3 MHz or more to 3 MHz or less), a short wave (HF, 3 MHz or more to 300 MHz or less), a ultrashort wave (VHF, 30 MHz or more to 300 MHz or less), and a microwave (UHF, 300 MHz or more). It has been difficult to obtain the characteristics of electromagnetic wave shield by a dense body containing a carbon material. In the dense material including the carbon nanohorns in the present teaching, the dense material including 99.5% or more of the carbon nanohorns has superior characteristics of electromagnetic wave shield compared with the dense material containing 3% of tungsten (W) and 97% of the carbon nanohorns in the present teaching.

The characteristics of electromagnetic wave shield can be measured according to the known KFC method (by KEC Electronic Industry Development Center). The measurement was performed at the measurement frequency of 10 MHz or more to 1000 MHz, a distance between a sending part and a receiving part of 10 mm, about 20°C, and 65%RH.

The dense material of carbon nanohorn, disclosed in the present description has the above-described favorable characteristics of electromagnetic wave shield. Thus, the dense material can be used in wave absorber, electromagnetic wave absorber, wire coating, and coaxial cable coating. Therefore, an electromagnetic shield material containing the dense material of the present teaching can also be provided.

### [First Embodiment]

The present teaching is described in detail below with reference to the embodiments. The present teaching, however, is not limited by the following embodiments. In the embodiments, production of carbon nanohorn by the production method of the present teaching is described.

### [Second Embodiment]

The present embodiment is described as a favorable example of a device of FIGS. 1A and IB.. The graphite positive electrode and the negative electrode are disposed in the fluid bath with a water depth of about 30 cm so that the electrodes face each other in the vertical direction in relation to force of gravity at a distance of 1 mm from each other. The graphite positive electrode has a cylindrical shape with a diameter of 3 mm and a length of 100 mm and is obtained using 1.5 g of carbon rods with a carbon purity of 99.999%. The fluid bath is filled with 20 L of aqueous solution, and the fluid bath is then sealed with a lid. A DC voltage of 20 V, 60 A is applied to the graphite positive electrode and the negative electrode. Carbon particles are then synthesized by supplying nitrogen gas at at a set value (20 L/min to 25 L/min) to the introducing path of the negative electrode. At that time, a gap between the graphite anode and the cathode is adjusted by automatic control of a support supporting the cathode so as to maintain 1 mm. Water around the water level in the fluid bath is temporally aspirated with a pump and caused to pass through a UF membrane filter to separate water and particles by filtration. The particles separated by filtration were dried by spray drying. Thus, purified particles were obtained. The particles were observed by an electron microscope and found that many single-layer carbon nanohorns are included. The time required to consume 80% of carbon rod was about 30 seconds, about 1.4 grams of carbon nanohorns were obtained per 1 minute.

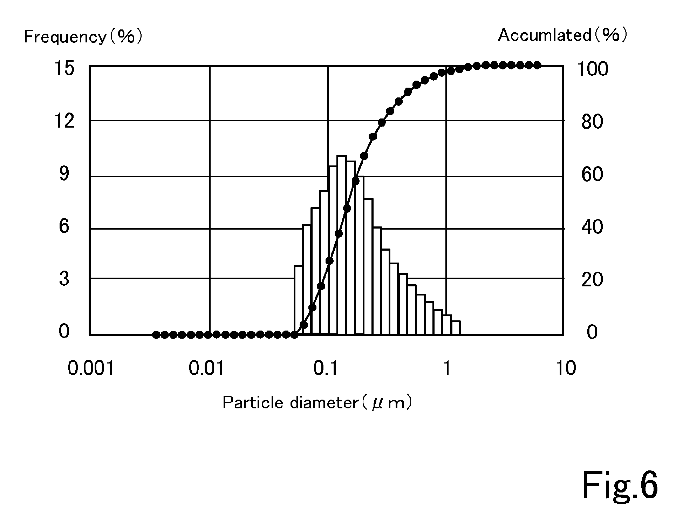

A particle size distribution of the obtained carbon nanohorns was measured. The result obtained by the measurement of the particle size distribution at the time when a carbon nanomaterial was dispersed using Newcol 740 (concentration: 60%) that is a nonionic surfactant is shown in FIG. 6. The dispersion of particle diameters is shown as a normal distribution. The particle size distribution of the carbon nanohorns obtained in the present example is as follows: 10% cumulative diameter is 0.0712 µm, 90% cumulative diameter is 0.4675 µm, cumulative median diameter (50%) is 0.1539 µm, average diameter is 0.0834 µm, and standard deviation is 0.1357. Meanwhile, when no surfactant is used, the standard distribution is not followed and 10% cumulative diameter is 0.1227 µm, 90% cumulative diameter is 4.9431 µm, cumulative median diameter (50%) is 0.3493 µm, average diameter is 0.1093 µm, and standard deviation 0.5373.

As described above, a large amount (20 to 100 times or more) of carbon nanomaterial could be obtained using one device, compared with the conventional method for producing a carbon nanomaterial on the basis of arc discharge. A large facility is not required, and a space required for one device is 0.25 m2 which is small. That is, a carbon nanomaterial can be efficiently produced at low cost. Moreover, the particle size distribution was normal distribution, and a carbon nanomaterial with similar particle diameter can be produced.

### [Third Embodiment]

In the present embodiment, a carbon nanomaterial was produced using a graphite anode in a size that is different from the first embodiment. The description of the same members and the same operations were omitted. In the present embodiment, as the graphite anode, a carbon rod having a diameter of 6.8 mm, a length of 100 mm, a cylindrical shape, and a carbon purity of 99.999% was used. As the cathode, a carbon rod, which has a diameter of 12.3 mm and in which a nitrogen gas introduction path was formed, was used. The graphite anode and the cathode was placed in a fluid bath so as to face each other at a distance of 1 mm, and the fluid bath was filled with purified water, and thereafter, a direct current at 140 A was applied under introduction of nitrogen gas (20 to 25 litters/minute) to generate a carbon nanomaterial. The generated carbon nanomaterial was separated by filtration. Thus, 3 to 4 times as much carbon nanohorns as that in the first embodiment were obtained.

As described above, even when both of the cathode and the anode contain graphite, a carbon nanomaterial can be produced. Further, energy profiles of the region in which arc discharge is generated can be controlled by the amount of the current to be applied. Thus, a large amount of carbon nanomaterial can be efficiently synthesized.

### [Fourth Embodiment]

In the present embodiment, various evaluations of the carbon nanomaterial (carbon nanohorns) produced according to the first embodiment by the purity, the pore volume, the thermal gravity, Raman spectroscopic analysis, and TEM observation were performed as follows.

### (1) Purity

Na, K, Mg, Ca, Fe, Si, and Cl in the carbon nanomaterial were measured. Na and K were measured by atomic spectrophotometry, and Mg, Ca, Fe, and Si were measured by ICP atomic emission spectroscopy, and Cl was measured by an absorption/combustion IC method. The results of the measurements are shown in Table 1.

**[Table 1]**

| | Na | K | Mg | Ca | Fe | Si | Cl |
|---|---|---|---|---|---|---|---|
| Content(wt%) | 0.03 | 0.009 | 0.005 | 0.044 | 0.064 | 0.021 | 0.04 |

As shown in Table 1, the carbon nanomaterial contained trace amounts of metal elements and the like. It was considered that these metal elements were derived from metal elements and the like contained in water of a water tank.

### (2) Pore volume

The pore volume was measured by a nitrogen absorption method. The sample was pre-treated by vacuum degassing at 120°C for 5 hours, and thereafter, an isothermal line of nitrogen adsorption and desorption was measured by a constant volume method. As a measurement device, BELSORP-mini (manufactured by BEL Japan Inc.) was used. The absorption temperature was 77 K, a saturated vapor pressure was an actual measurement value, an adsorbate was nitrogen, and the cross-sectional area of the adsorbate was 0.162 m2. The pore volume was calculated by the BJH method. The result of the calculation is shown in Table 2.

As shown in Table 2, the pore volume was 1.08 cm3/g. Specifically, since the pore volume is big, it was found that the carbon nanohorns of the present teaching can be favorably used in various uses utilizing the structures of carbon nanohorns, such as in a catalyst, an absorbent, and a carrier.

**[Table 2]**

| Pore volume cm³/g |
|---|
| 1.08 |

### (3) Thermo gravimetry/differential thermal analysis

The change in weight and the change by heat, of the sample in the temperature range from room temperature to 1400°C were measured. A cell was Pt, the amount of the sample was about 3 g, the rate of temperature increase was 10°C/minute, and the atmosphere was air at 200 ml/minute, and the measurement was performed using a thermo gravimetry/differential thermal analyzer TG/DTA 300 (manufactured by Seiko Electron Co. Ltd.). The results of the measurement are shown in Table 3.

**[Table 3]**

| | Temperature (°C) | Weight change (wt%) | Peak temperature (°C) |
|---|---|---|---|
| Read-out value | 212 | -2 | |
| | 543 | -60 | 503°C |
| | 773 | -100 | 649°C |
| | 1400 | -99 | |

As shown in Table 3, two-stage weight reduction of the carbon nanomaterial with heat was observed. The flammability peak was at 503°C and 649°C.

### (4) Raman spectroscopic analysis

The Raman spectroscopic analysis was performed under the following conditions. A G band at about 1590 cm-1, derived from the graphite structure, was detected. The measurement conditions are as follows. The laser wavelength was 532 nm, the laser output was 1%, the magnification (objective lens) was 10-fold magnifications, the slit was a pinhole with 100 µm, the measurement wavelength range was about 4000 to 200 cm-1, the time of exposure to light was 30 seconds, the number of exposures to light was 10.

### (Shape, Size)

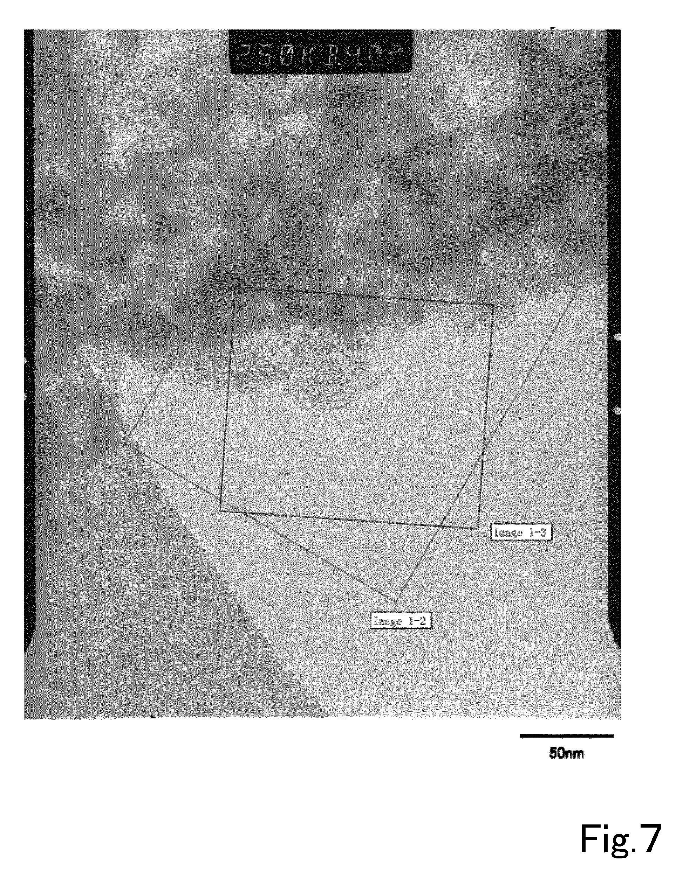

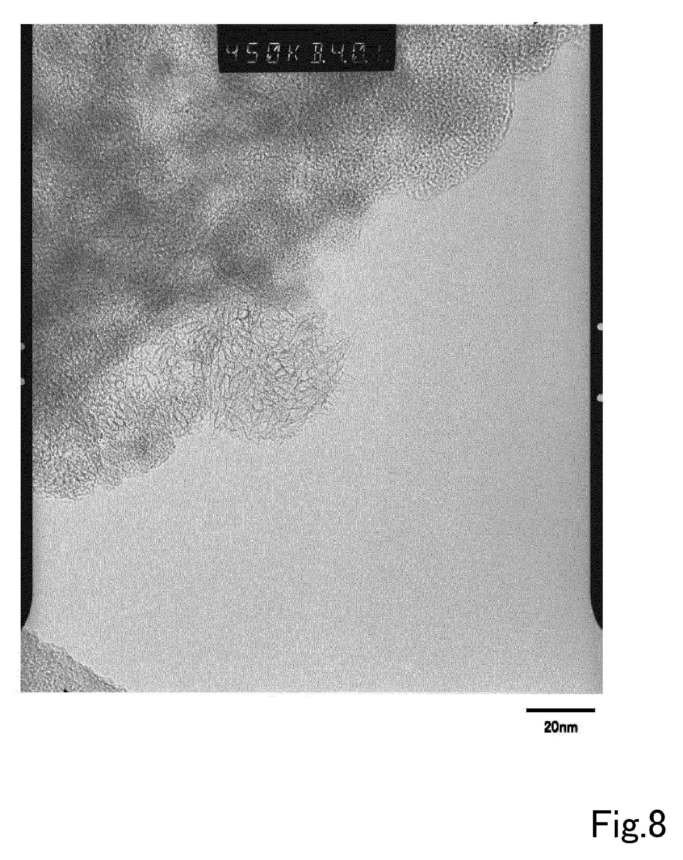

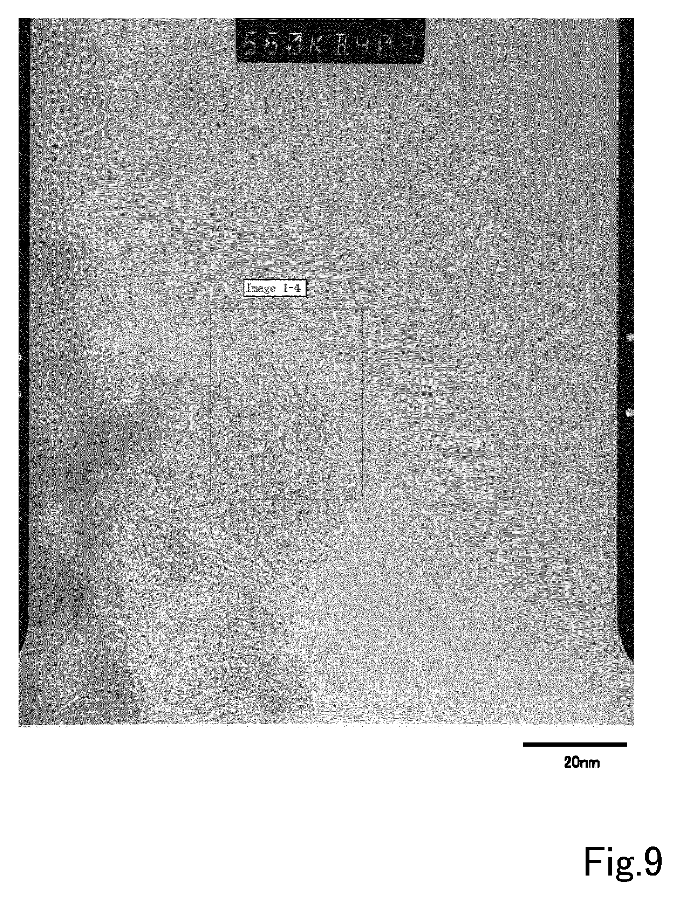

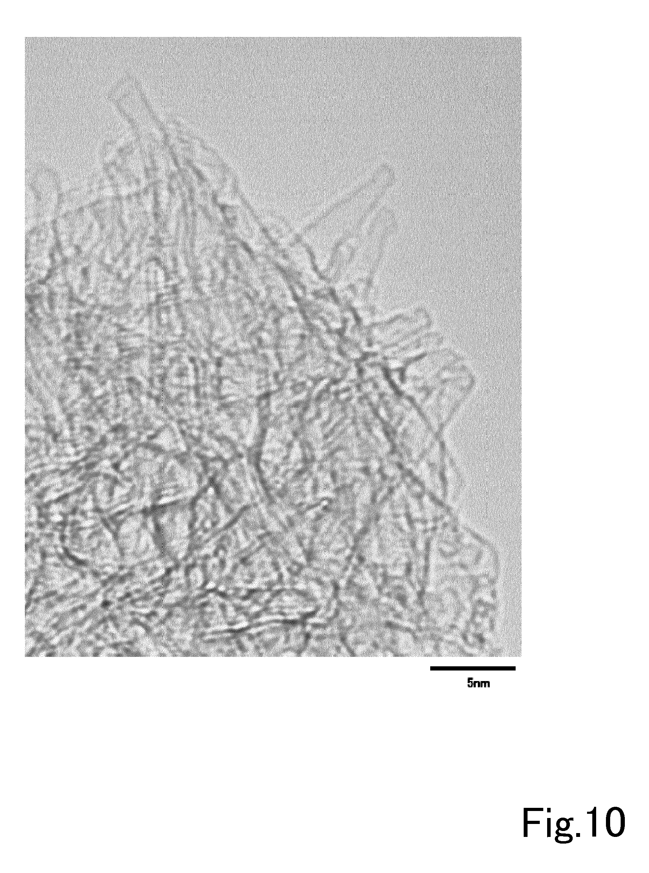

The carbon nanomaterial was observed by TEM. The condition of the observation by TEM was an acceleration voltage: 120 kV measured by CM20FEG manufactured by Philips. The results are shown in FIGS. 7 to 10. As shown in FIGS. 7 to 10, the carbon nanomaterial configures secondary particles obtained by aggregating individual carbon nanohorns, and the size of the secondary particle is about 40 nm or more to about 60 nm or less. It was found that most of the lengths of the individual carbon nanohorns are 30 nm or less.

### [Fifth Embodiment]

A stem of cut flower having a blooming flower was immersed in a liquid obtained by adding, mixing, and dispersing 10 mg of carbon nanohorns obtained in the third embodiment in 10 ml of water, and a change over time was observed. In the observation, water was not replaced. As a comparative example, a stem of the same kind of cut flower having a blooming flower was immersed in water containing no carbon nanohorn. The results are as follow.

The day of immersing: there was no change in blooming state of cut flowers immersed in water containing carbon nanohorns and water containing no carbon nanohorn.

One day after the immersing: there was no major change in petal of the cut flower immersed in the water containing carbon nanohorns from the day of immersing. In contrast, the petal of the cut flower of the comparative example, immersed in the water containing no carbon nanohorn was started to shrink.

Three days after the immersing: there was no major change in petal of the cut flower immersed in the water containing carbon nanohorns from the day of immersing. In contrast, the petal of the cut flower of the comparative example, immersed in the water containing no carbon nanohorn was further shrunk.

Four days after the immersing, the petal of the cut flower immersed in the water containing carbon nanohorns was barely started to fade, but was not shrunk. In contrast, the petal of the cut flower of the comparative example, immersed in the water containing no carbon nanohorn was further shrunk.

It was found from the results that the plant activity can be maintained, such as keeping the freshness of plants and extending the blooming state by adding the carbon nanohorns of the present teaching to water to be supplied to plants.

### [Sixth Embodiment]

In the present example, a dense molding was produced using the carbon nanohorn obtained in the first embodiment. Moreover, a molding was produced using a tungsten-supported carbon nanohorns synthesized under the same conditions as in the first embodiment except that a graphite plated with tungsten to have a predetermined thickness was used as a cathode. The production conditions and evaluation results of the molding are shown in the following table. As alumina, α-alumina (commercially available product) was used.

As pressurizing and heating devices, a Sumitomo Coal Mining spark plasma sintering device SPS-515S (the maximum molding pressure: 50 kN, the maximum pulse current output: 1500 A, manufactured by SPS Syntex Co., Ltd.) and a Sumitomo Coal Mining spark plasma sintering device SPS-3.20S (the maximum molding pressure: 200 kN, the maximum pulse current output: 8000 A) were used. These devices were used in production of pellets with diameters of 15 mm and 30 mm.

As the condition of mixing a molding material and alumina (mixing ratio: alumina : carbon nanohorn =97:3 (% by mass), wet mixing was performed using a planetary boll mill P-5 type (manufactured by Fritsch Japan Co., Ltd.) and n-hexane as a dispersion medium in a pot made of alumina. After the mixing, the mixture was dried in a drier at 50°C for 2 hours. The molding material of a single material was subjected to tests as it was.

The sintering atmosphere was vacuum, and cooling was performed by exposure to the atmosphere at the time when the pellet temperature reached 250°C after stopping energization and pressurization.

**[Table 4]**

| Material | | CNH | Alumina : CNH (97 : 3) | | Tungsten-supported CNH | |
|---|---|---|---|---|---|---|
| The use amount (g)/Pelet | | 0.4g/ *φ* 15 | 7g/ *φ* 30 | | 0.5g/ *φ* 15 | |
| Applied pressure kM | | 20 | 40 | 40 | 20 | 20 |
| Temperature rising condition | | 119 minutes (1050° C to) | 25 minutes (600° C to) | 25 minutes (600° C to) | 119 minutes (1050° C to) | 119 minutes (1050 °C to) |
| The final temperature °C | | 2000 | 1400 | 1400 | 2000 | 2000 |
| Holding time min at find | | 20 | 0 | 0 | 20 | 20 |
| Sintered body | Apperance | Favorable | Favorable | Favorable | Favorable | Favorable |
| | Density of sintered body g/cm³ | 1.27 | 3.6 | 3.6 | 1.23 | 1.21 |

As shown in Table 4, a molding with a density of more than 1 which was favorable could be obtained from simple carbon nanohorns Moreover, the moldability and the density of the composite material with alumina also were favorable. Furthermore, the moldability and the density of tungsten-supported carbon nanohorns also were favorable It was assumed that these results were caused by the characteristics of the carbon nanohorns used as a raw material. It is considered from the moldability and the density that the applicable range of the carbon nanohorns is expanded to various uses

### [Seventh Embodiment]

In the present embodiment, a dense molding (diameter: 15 mm) of carbon nanohorns alone, obtained in the firth embodiment, a dense molding (diameter: 30 mm) of alumina-containing carbon nanohorns, and a dense molding using carbon nanohorns and tungsten, obtained in the first embodiment were produced, and the characteristics of electromagnetic wave shield were evaluated. As a reference example, a commercially available alumina sintered molding was used

### (Tungsten-contaimng carbon nanohorn molding)

97 wt% of the carbon nanohorns produced in the first embodiment and 3 wt% of tungsten were mixed in the same manner as in the fifth embodiment The powder fill amount (the sample amount) was 0.44 g, a pressure was 20 MPa under vacuum, a temperature rising condition was 119 minutes (1050°C to), and the maximum temperature was 2000°C, the holding time was 20 minutes. Natural cooling was performed after stopping energization and pressurization, and cooling was performed by exposure to the atmosphere at the time when the pellet temperature reached 250°C. The obtained molding (diameter: 15 mm) had a diameter of 15.34 mm, a thickness of 1.97 mm, and a density of 1.21 g/cm3.

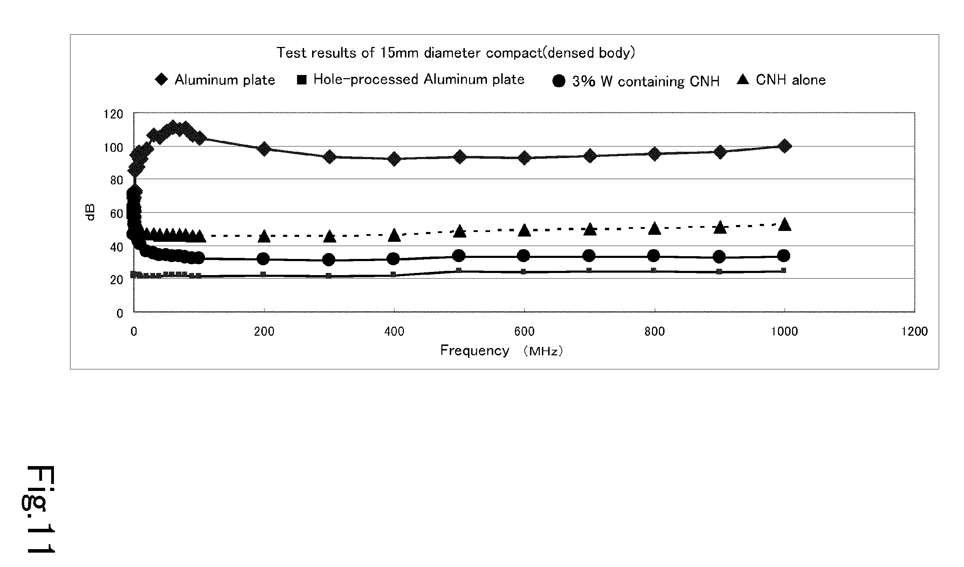

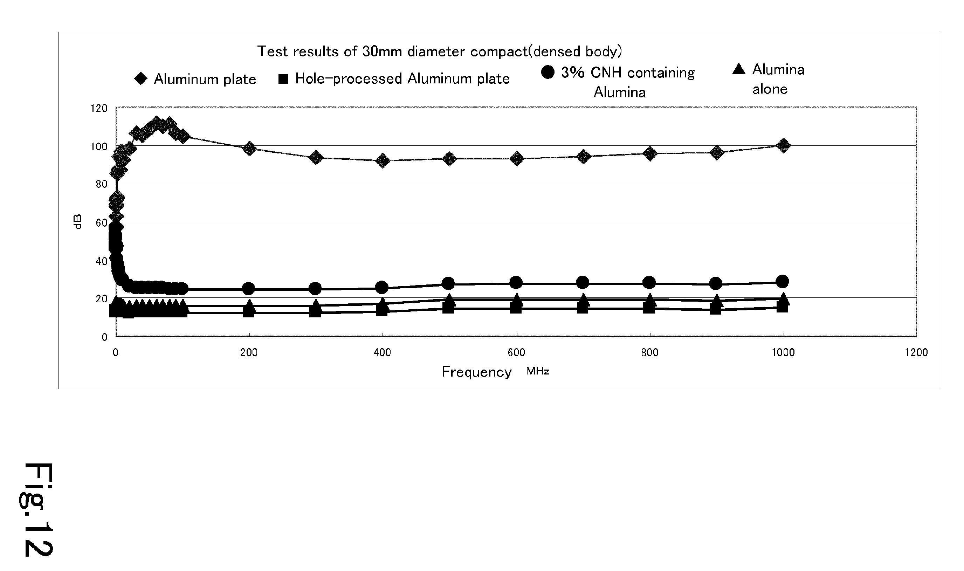

The characteristics of electromagnetic wave shield were measured by the following methods according to the KEC method, considering the size of each molding sample. That is, an aluminum plate with 200 mm x 236 mm and a thickness of 1 mm and an aluminum plate obtained by subjecting the aluminum plate with hole processing of a diameter of 15 mm or 30 mm were provided, and three kinds of the aluminum plate with no hole, the hole-processed aluminum plate, and an aluminum plate obtained by arranging a molding sample in a hole-processed part of the hole-processed aluminum plate were subjected to tests. The measurement condition was 20°C and 65%RH. The results are shown m Table 5 (molding with a hole diameter of 15 mm) and Table 6 (molding with a hole diameter of 30 mm) and FIGS. 11 and 12.

**[Table 5]**

| Frequency | Aluminum plate | Hole-processed aluminum plate | 3% W-containing CNH | CNH |
|---|---|---|---|---|
| [MHz] | [dB] | [dB] | [dB] | [dB] |
| 0.1 | 47.4495 | 22.30621 | 46.6155 | 49.80631 |
| 0.2 | 56.71925 | 21.79746 | 57.49232 | 58.4536 |
| 0.3 | 57.33405 | 21.65188 | 61.8673 | 67.84106 |
| 0.4 | 62.78143 | 21.68463 | 62.00606 | 66.50959 |
| 0.5 | 68.95562 | 21.85629 | 70.39667 | 65.55372 |
| 0.6 | 68.08851 | 21.88537 | 62.81947 | 69.83724 |
| 0.7 | 71.16702 | 21.68725 | 59.98467 | 63.75385 |
| 0.8 | 72.02359 | 21.77396 | 60.78253 | 64.76606 |
| 0.9 | 72.86193 | 21.7036 | 57.34125 | 63.53039 |
| 1 | 72.89457 | 21.88757 | 58.54224 | 6437661 |
| 2 | 84.8623 | 21.78834 | 52.31728 | 57.37636 |
| 3 | 87.16487 | 21.86483 | 49.23803 | 54.5753 |
| 4 | 87.50948 | 21.82021 | 47.05278 | 53.46635 |
| 5 | 94.19919 | 21.84705 | 45.39668 | 52.03082 |
| 6 | 87 32523 | 21.81763 | 44.0425 | 51.37693 |
| 7 | 92.31357 | 21.84819 | 43.17348 | 50.7047 |
| 8 | 96.43694 | 21.81741 | 42.1067 | 49.92548 |
| 9 | 92.39365 | 21.72783 | 41.39584 | 4961998 |
| 10 | 92.12717 | 21.65542 | 40.6539 | 48.96207 |
| 20 | 98.02109 | 21.28857 | 36.42081 | 47.14356 |
| 30 | 106.058 | 21.46941 | 34.94804 | 46.6985 |
| 40 | 105.1926 | 21.64247 | 34.11174 | 46.56521 |
| 50 | 108.5284 | 21.74203 | 33.68161 | 46.50584 |
| 60 | 111.306 | 21.83714 | 33.32505 | 46.49068 |
| 70 | 109.9114 | 21.86536 | 32.98386 | 46.39184 |
| 80 | 110.727 | 21.69611 | 32.57607 | 46.13447 |
| 90 | 106.2789 | 21.48257 | 32.10474 | 45.84061 |
| 100 | 104.7826 | 21.63094 | 32.00933 | 45.92265 |
| 200 | 98.18475 | 21.81842 | 31.28135 | 45.85633 |
| 300 | 93.24995 | 21.65793 | 30.7989 | 45.71909 |
| 400 | 91.95171 | 22.2721 | 31.35273 | 46.61433 |
| 500 | 92.97886 | 24.24303 | 33.25256 | 48.93433 |
| 600 | 92.74025 | 24.05541 | 33.0663 | 4923226 |
| 700 | 93.89197 | 24.10471 | 33 09046 | 4990319 |
| 800 | 95.34053 | 24.26746 | 33.14815 | 50.74174 |
| 900 | 96.32809 | 23.75565 | 32.58189 | 5110749 |
| 1000 | 99.97221 | 24.49651 | 33.22793 | 5302438 |
| Average | 88.65 | 22.16 | 43.17 | 53.01 |

**[Table 6]**

| Frequency | Aluminum plate | Hole-processed aluminum plate | 3% CNH-containing Alumina | Simple alumina |
|---|---|---|---|---|
| [MHz] | [dB] | [dB] | [dB] | [dB] |
| 0.1 | 47.4495 | 13.26406 | 45.762 | 17.84974 |
| 0.2 | 56.71925 | 12.59347 | 52.51593 | 16.72238 |
| 0.3 | 57.33405 | 12.35374 | 56.36601 | 1607277 |
| 0.4 | 62.78143 | 12.35091 | 52.54195 | 16.49088 |
| 0.5 | 68.95562 | 12.41816 | 50.91589 | 16.55682 |
| 0.6 | 68.08851 | 12.42621 | 48.16209 | 16.408 |
| 0.7 | 71.16702 | 12.3879 | 48.50665 | 16.35254 |
| 0.8 | 72.02359 | 12.32036 | 47.26077 | 16.52847 |
| 0.9 | 72.86193 | 12.37805 | 46.54031 | 16.32141 |
| 1 | 72.89457 | 12.39679 | 45.52703 | 16.26092 |
| 2 | 84.8623 | 12.35426 | 40.33768 | 16.2527 |
| 3 | 87.16487 | 12.39936 | 37.12998 | 16.24182 |
| 4 | 87.50948 | 12.41732 | 34.97399 | 16.24607 |
| 5 | 94.19919 | 12.42735 | 33.28217 | 16.21503 |
| 6 | 87.32523 | 12.40509 | 31.81776 | 16.21138 |
| 7 | 92.31357 | 12.43233 | 30.91912 | 16.18827 |
| 8 | 96.43694 | 12.40907 | 30.05422 | 16.23468 |
| 9 | 92.39365 | 12.31804 | 29.2692 | 16.123 |
| 10 | 92.12717 | 12.23832 | 29.10369 | 16.03465 |
| 20 | 98.02109 | 11.85051 | 26.12923 | 15.63769 |
| 30 | 106.058 | 12.02509 | 25.19653 | 15.74085 |
| 40 | 105.1926 | 12.22137 | 24.99654 | 15.90401 |
| 50 | 108.5284 | 12.31814 | 24.91957 | 16.0216 |
| 60 | 111.306 | 12.42437 | 24.93352 | 16.14906 |
| 70 | 109.9114 | 12.46738 | 24.8529 | 16.17426 |
| 80 | 110.727 | 12.30137 | 24.56664 | 15.97001 |
| 90 | 106.2789 | 12.0974 | 24.26094 | 15.73277 |
| 100 | 104.7826 | 12.20541 | 24.39869 | 15.9007 |
| 200 | 98.18475 | 12.39236 | 24.42929 | 16.11251 |
| 300 | 93.24995 | 12.1813 | 24.32383 | 16.04596 |
| 400 | 91 95171 | 12.69215 | 25.19545 | 16.87594 |
| 500 | 92.97886 | 14.57915 | 27.33481 | 18.99632 |
| 600 | 92.74025 | 14.30249 | 27.43108 | 19.04335 |
| 700 | 93.89197 | 14.28871 | 27.65725 | 19.23599 |
| 800 | 95.34053 | 14.46205 | 27.7215 | 19.33088 |
| 900 | 96.32809 | 13.9519 | 27.23647 | 18.80397 |
| 1000 | 99.97221 | 14.70764 | 27.89199 | 19.47095 |
| Average | 88.65 | 12.70 | 33.90 | 16.72 |

As shown in Tables 5 and 6 and FIGS. 11 and 12, dense samples obtained by sintering have superior characteristics of electromagnetic wave shield over a broad frequency range. In the average of all frequency range, the results were 240% in the molding of the only carbon nanohorn, 195% in the tungsten-containing molding, and 267% in the alumina-containing molding. That is, a dense molding containing 3% tungsten and 97% carbon nanohorn can maintain favorable characteristics of electromagnetic wave shield. By only containing 3% carbon nanohorns of the present teaching in alumina, high characteristics of electromagnetic wave shield can be exerted. As described about, it was found that the carbon nanohorns of the present teaching is a material of which a superior electromagnetic shield material can be obtained, and the dense material of the present teaching including the carbon nanohorns of the present teaching is a favorable electromagnetic shield material. Moreover, it was found that an electromagnetic shield material containing the dense material of the present teaching can be provided.

## Claims

1. A dense material comprising a carbon nanohorn,
the material being a dense composite material containing a carbon nanohorn and having a predetermined three-dimensional shape.

2. The dense material according to claim 1, which is a burned body.

3. The dense material according to claim 1 or 2, which has a density of 1.0 g/cm3 or more.

4. The dense material according to any of claims 1 to 3, wherein the pore volume of the carbon nanohorn is 0.8 cm3/g or more.

5. The dense material according to any of claims 1 to 4, wherein
the carbon nanohorn relates to one or more elements selected from the group consisting of Na, K, Mg, Ca, Fe, Si, and Cl and contains the one or more elements in the following contents:
Na: 0.003% or more to 0.3% or less;
K: 0.001% or more to 0.1 % or less;
Mg: 0.0005% or more to 0.05% or less;
Ca: 0.004% or more to 0.4% or less;
Fe: 0.006% or more to 0.6% or less;
Si: 0.002% or more to 0.2% or less; and
Cl: 0.004% or more to 0.4% or less.

6. The dense material according to any of claims 1 to 5, wherein the carbon nanohorn is composed mainly of a carbon nanohorn with a length of 30 nm or less.

7. The dense material according to any of claims 1 to 6, comprising a metal-supporting carbon nanohorn.

8. The dense material according to any of claims 1 to 7, further comprising a ceramics material.

9. The dense material according to any of claims 1 to 7, substantially comprising the carbon nanohorn.

10. An electromagnetic shield material, comprising the desnse material according to any of claims I to 9.

11. A method for producing a dense material containing carbon nanohorns,
the method comprising:
preparing a molding material containing a carbon nanohorn produced by arc discharge in a fluid; and
heating and molding the molding material under pressure to produce the dense material according to any of claims 1 to 9.

12. The method according to claim 11, wherein the molding material is prepared by mixing and drying the carbon nanohorn and another material in an aqueous medium.

13. The method according to claim 11 or 12, wherein the molding material is pressurized at 20 kN or more and heated at 1000°C or more.
